(19) Europäisches Patentamt
European Patent Office
Office européen des brevets

(11) **EP 3 555 917 B1**

(12) **EUROPEAN PATENT SPECIFICATION**

(45) Date of publication and mention
of the grant of the patent:
**20.09.2023 Bulletin 2023/38**

(21) Application number: **17825302.7**

(22) Date of filing: **12.12.2017**

(51) International Patent Classification (IPC):
**H01L 27/146** *(2006.01)*

(52) Cooperative Patent Classification (CPC):
**H01L 27/14621; H01L 27/14625; H01L 27/14645;**
H01L 27/14618; H01L 27/14627; H01L 27/1464

(86) International application number:
**PCT/JP2017/044627**

(87) International publication number:
**WO 2018/110571 (21.06.2018 Gazette 2018/25)**

(54) **IMAGING ELEMENT, METAL THIN FILM FILTER, AND ELECTRONIC DEVICE**

BILDGEBUNGSELEMENT, METALLDÜNNSCHICHTFILTER UND ELEKTRONISCHE
VORRICHTUNG

ÉLÉMENT D'IMAGERIE, FILTRE À FILM MINCE MÉTALLIQUE ET DISPOSITIF ÉLECTRONIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **13.12.2016 JP 2016241254**

(43) Date of publication of application:
**23.10.2019 Bulletin 2019/43**

(73) Proprietor: **Sony Semiconductor Solutions
Corporation
Atsugi-shi, Kanagawa 243-0014 (JP)**

(72) Inventor: **SUGIZAKI Taro
Atsugi-shi
Kanagawa 243-0014 (JP)**

(74) Representative: **MFG Patentanwälte
Meyer-Wildhagen Meggle-Freund
Gerhard PartG mbB
Amalienstraße 62
80799 München (DE)**

(56) References cited:
EP-A1- 2 432 019          WO-A1-2011/078254
WO-A1-2012/032939      WO-A1-2014/199720
US-A1- 2008 170 143      US-A1- 2010 046 077
US-A1- 2015 206 912

## Description

### Technical Field

The present technology relates to an imaging element, a metal thin film filter, and an electronic device, and for example, relates to an imaging element, a metal thin film filter, and an electronic device, in which only an electromagnetic wave component at a specific wavelength can be selectively taken out.

### Background Art

Recently, an electronic device, such as a digital still camera or a camcorder, has increased in which a subject is shot and imaged by an imaging element. Currently, examples of a mainstream imaging element include a charge coupled device (CCD) image sensor, a complementary metal oxide semiconductor (CMOS) image sensor, or the like. Furthermore, hereinafter, such imaging elements will be collectively referred to as an image sensor. The image sensor has wide sensitivity from a visible wavelength to a near infrared ray wavelength.

However, it is not possible for the image sensor to distinguish color information items as with human eyes, for example, to distinguish red light from blue light. For this reason, in the image sensor of the related art, a color filter transmitting only an electromagnetic wave at a specific wavelength of red (R), green (G), blue (B), a complementary color (cyan (Cy), magenta (Mg), yellow (Ye), and green (G)), or the like, is built in a front surface of each pixel. By using such an image sensor of the related art, sensitivity information of each color is acquired from transmission light sensitivity, and signal processing or the like is performed with respect to the sensitivity information of each color, and thus, color imaging is performed.

An organic material such as a pigment or a colorant is generally used in the color filter adopted in such an image sensor of the related art. However, bonding energy of molecules including carbon or hydrogen, which is a constituent element of the color filter, is the same degree as that of ultraviolet ray energy. Accordingly, in a case where the color filter is irradiated with light of high energy for a long period of time, there is a case where a carbon bond or a bond between carbon and hydrogen is broken. For this reason, in a case where the color filter is used in the outdoor to be exposed to solar light including an ultraviolet ray for a long period of time or is used under an environment where an ultraviolet ray is particularly strong, transmission characteristics of the color filter are changed. As a result thereof, there is a possibility that color reproduction characteristics of the imaging image are degraded.

Therefore, a color filter using an inorganic substance or photonic crystals has also been gradually practically used (for example, refer to PTL 1 and PTL 2). Further, a wire grid or a color filter referred to as a metal optical filter has also appeared (for example, refer to NPL 1 to NPL 3).

US 2008/170143 A1 relates to a solid-state imaging device, which includes a photodiode, and a metal optical filter formed above the photodiode that allows light of a desired wavelength to be transmitted. The metal optical filter is made of a metal thin film in which plural cylinder-shaped apertures are periodically arrayed. The size of each of the apertures is smaller than the desired wavelength, and an inter-aperture distance between a predetermined aperture and an aperture adjacent to the predetermined aperture is shorter than the desired wavelength.

EP 2 432 019 A1 pertains to an imaging device, which includes a photoelectric conversion layer in which photoelectric conversion devices that convert received light into charge are arranged in a planar fashion; and a conductor structure layer provided on an upper surface or a lower surface of the photoelectric conversion layer and formed by stacking plural conductor layers having conductor metals with concavo-concave structures at predetermined periodic intervals within a plane in parallel to light receiving surfaces of the photoelectric conversion devices.

### Citation List

#### Patent Literature

PTL 1: Re-publication of PCT International Publication No. 2006/028128
PTL 2: Re-publication of PCT International Publication No. 2005/013369

#### Non Patent Literature

NPL 1: Quasioptical Systems, Paul F. Goldsmith, IEEE Press, ISBN 0-7803-3439-6

# EP 3 555 917 B1

NPL 2: J. Opt. Soc. Am. A, P.B.Catrysse & B.A.Wandell, Vol.20, No.12, December 2003, p.2293-2306

NPL 3: Nanotechnology, Seh-Won Ahn et al., Vol.16, 1874-1877, 2005 (LG)

## Summary of Invention

### Technical Problem

In the image sensor, it is necessary to realize a technology of selectively taking out only an electromagnetic wave component at a specific wavelength to be physically and chemically stable at low cost. However, in the color filter of the related art including PTL 1, PTL 2, and NPL 2 to NPL 3, such necessity is not sufficiently satisfied.

The present technology has been made in consideration of such circumstances described above, and is capable of selectively taking out a specific electromagnetic wave wavelength.

### Solution to Problem

According to a first aspect, the invention provides an imaging device in accordance with independent claim 1. According to a second aspect, the invention provides an imaging device in accordance with independent claim 6. According to a third aspect, the invention provides an imaging method in accordance with independent claim 8. Further aspects of the invention are set forth in the dependent claims, the drawings and the following description.

According to the present disclosure, an imaging device is provided comprising a polarizer configured to linearly polarize light along a polarization direction, a filter layer configured to receive polarized light from the polarizer and selectively filter light according to wavelengths of the polarized light, and a photoelectric conversion layer configured to receive light filtered by the filter layer and to produce an electric charge in response to the received light, wherein the filter layer comprises a plurality of through holes formed therein, wherein through holes of the plurality of through holes have a cross-sectional shape that extends a greater amount in the polarization direction than in a direction perpendicular to the polarization direction.

Further according to the present disclosure, an imaging device is provided comprising a polarizer configured to linearly polarize light along a polarization direction, a filter layer configured to receive polarized light from the polarizer and selectively filter light according to wavelengths of the polarized light, and a photoelectric conversion layer configured to receive light filtered by the filter layer and to produce an electric charge in response to the received light, wherein the filter layer comprises a dot array formed therein, wherein dots of the dot array have a cross-sectional shape that extends a greater amount in the polarization direction than in a direction perpendicular to the polarization direction.

Further according to the present disclosure, an imaging device is provided comprising a filter layer configured to receive polarized light and selectively filter light according to wavelengths of the polarized light, and a photoelectric conversion layer configured to receive light filtered by the filter layer and to produce an electric charge in response to the received light, wherein the filter layer comprises a plurality of through holes and/or a plurality of dots formed therein, wherein holes and dots of the plurality of through holes and/or plurality of dots have an elliptical cross-section wherein a major axis of the ellipse is aligned in the polarization direction.

Further according to the present disclosure, an imaging method is provided, the method comprising receiving light polarized along a polarization direction, selectively filtering the received light by a filter layer according to wavelengths of the polarized light, the filter layer comprising a plurality of through holes and/or a plurality of dots formed therein, wherein holes and dots of the plurality of through holes and/or plurality of dots have a cross-sectional shape that extends a greater amount in the polarization direction than in a direction perpendicular to the polarization direction, and by a photoelectric conversion layer, receiving light filtered by the filter layer and producing an electric charge in response to the received filtered light.

### Advantageous Effects of Invention

According to one aspect of the present technology, it is possible to selectively take out a specific electromagnetic wave wavelength.

Furthermore, the effect described herein is not necessarily limited, and may be any effect described in the present disclosure.

### Brief Description of Drawings

[fig.1]Fig. 1 is a block diagram illustrating an embodiment of an imaging device to which the present technology is

3

applied.

[fig.2]Fig. 2 is a block diagram illustrating a configuration example of a circuit of an imaging element.

[fig.3]Fig. 3 is a sectional view schematically illustrating configuration example of the imaging element.

[fig.4]Fig. 4 is a diagram illustrating a configuration example of a plasmon filter having a pore array structure.

[fig.5]Fig. 5 is a graph illustrating a dispersion relationship of a front plasmon.

[fig.6]Fig. 6 is a graph illustrating a first example of spectral characteristics of the plasmon filter having the pore array structure.

[fig.7]Fig. 7 is a graph illustrating a second example of the spectral characteristics of the plasmon filter having the pore array structure.

[fig.8]Fig. 8 is a graph illustrating a plasmon mode and a waveguide mode.

[fig.9]Fig. 9 is a graph illustrating an example of propagation characteristics of the front plasmon.

[fig.10]Fig. 10 is a diagram illustrating another configuration example of the plasmon filter having the pore array structure.

[fig.11]Fig. 11 is a diagram illustrating a configuration example of a plasmon filter having a two-layer structure.

[fig.12]Fig. 12 is a diagram illustrating a configuration example of a plasmon filter having a dot array structure.

[fig.13]Fig. 13 is a graph illustrating an example of spectral characteristics of the plasmon filter having the dot array structure.

[fig.14]Fig. 14 is a diagram illustrating configuration example of a plasmon filter using GMR.

[fig.15]Fig. 15 is a graph illustrating an example of spectral characteristics of the plasmon filter using GMR.

[fig. 16]Fig. 16 is a sectional view schematically illustrating a configuration example of the imaging element.

[fig.17]Fig. 17 is a diagram schematically illustrating an aspect of occurrence of flare of the imaging device.

[fig. 18]Fig. 18 is a diagram for describing a flare reducing method of the imaging device.

[fig.19]Fig. 19 is a graph illustrating a first example of spectral characteristics of a narrow band filter and a transmission filter.

[fig.20]Fig. 20 is a graph illustrating a second example of the spectral characteristics of the narrow band filter and the transmission filter.

[fig.21]Fig. 21 is a graph illustrating a third example of the spectral characteristics of the narrow band filter and the transmission filter.

[fig.22]Fig. 22 is a sectional view schematically illustrating a configuration example of the imaging element.

[fig.23]Fig. 23 is a diagram for illustrating light transmission in a case where a polarizer and the plasmon filter are laminated.

[fig.24]Fig. 24 is a graph relevant to sensitivity of light transmitted through the plasmon filter.

[fig.25]Fig. 25 is a graph relevant to the sensitivity of the light transmitted through the plasmon filter.

[fig.26]Fig. 26 is a graph relevant to the sensitivity of the light transmitted through the plasmon filter.

[fig.27]Fig. 27 is a graph relevant to the sensitivity of the light transmitted through the plasmon filter.

[fig.28]Fig. 28 is a diagram for illustrating a laminated structure of the polarizer and the plasmon filter.

[fig.29]Fig. 29 is a diagram for illustrating the laminated structure of the polarizer and the plasmon filter.

[fig.30]Fig. 30 is a diagram illustrating a wire grid type polarizer.

[fig.31]Fig. 31 is a diagram illustrating arrangement of holes.

[fig.32]Fig. 32 is a diagram for illustrating a direction of an ellipse.

[fig.33]Fig. 33 is a diagram for illustrating the direction of the ellipse.

[fig.34]Fig. 34 is a diagram illustrating outlines of a configuration example of a laminated solid imaging device to which the present technology can be applied.

[fig.35]Fig. 35 is a diagram illustrating an application example of the present technology.

[fig.36]Fig. 36 is a diagram illustrating an example of a detection band in a case where the tastiness or the freshness of food is detected.

[fig.37]Fig. 37 is a diagram illustrating an example of a detection band in a case where a sugar content or the moisture of fruit is detected.

[fig.38]Fig. 38 is a diagram illustrating an example of a detection band in a case where plastic is sorted.

[fig.39]Fig. 39 is a diagram illustrating an example of a schematic configuration of an endoscopic surgery system.

[fig.40]Fig. 40 is a block diagram illustrating an example of a functional configuration of a camera head and CCU.

[fig.41]Fig. 41 is a block diagram illustrating an example of a schematic configuration of a vehicle control system.

[fig.42]Fig. 42 is an explanatory diagram describing an example of a disposition position of an outdoor information detecting unit and an imaging unit.

**Description of Embodiments**

Hereinafter, aspects for carrying out the present technology to will be described.

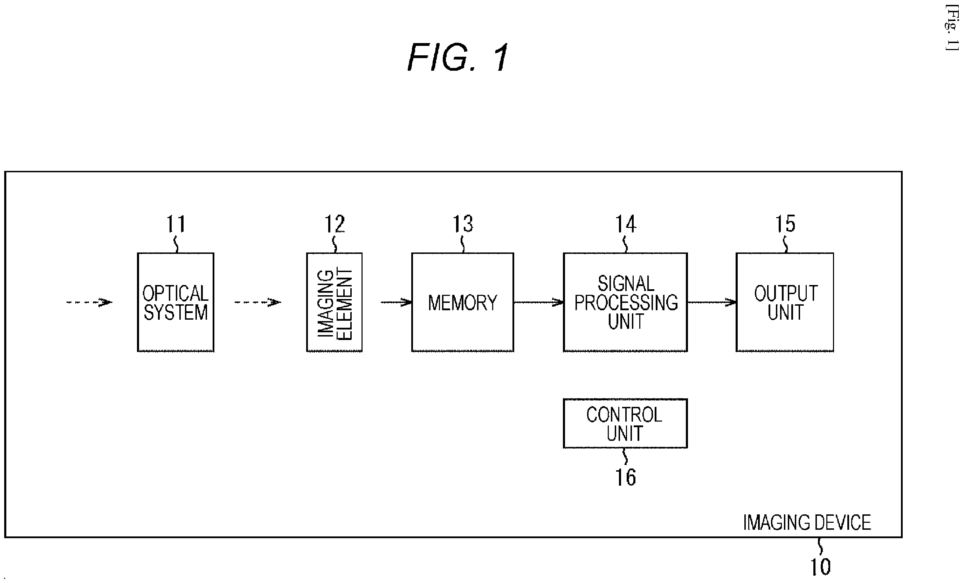

First, the present technology will be described with reference to Figs. 1 to 22.

<Configuration Example of Imaging Device>

Fig. 1 is a block diagram illustrating an imaging device, which is one type of electronic devices to which the present technology is applied.

An imaging device 10 of Fig. 1, for example, is formed of a digital camera which is capable of imaging both of a still image and a moving image. In addition, the imaging device 10, for example, is formed of a multispectral camera which is capable of detecting light (multi-spectrum) of four or more wavelength bands (four or more bands) greater than three wavelength bands (three bands) of the related art of R (red), G (green), and B (blue) or Y (yellow), M (magenta), and C (cyan), based on three primary colors or a color-matching function.

The imaging device 10 includes an optical system 11, an imaging element 12, a memory 13, a signal processing unit 14, an output unit 15, and a control unit 16.

The optical system 11, for example, includes a zoom lens, a focus lens, a diaphragm, and the like, which are not illustrated, and allows light from the outside to be incident on the imaging element 12. In addition, as necessary, various filters such as a polarization filter are disposed on the optical system 11.

The imaging element 12, for example, is formed of a complementary metal oxide semiconductor (CMOS) image sensor. The imaging element 12 receives incident light from the optical system 11, and performs photoelectric conversion, and thus, outputs image data corresponding to the incident light.

The memory 13 temporarily stores the image data which is output from the imaging element 12.

The signal processing unit 14 performs signal processing (for example, processing such as elimination of a noise and adjustment of a white balance) using the image data stored in the memory 13, and thus, supplies the image data to the output unit 15.

The output unit 15 outputs the image data from the signal processing unit 14. For example, the output unit 15 includes a display (not illustrated) configured of a liquid crystal or the like, and displays a spectrum (an image) corresponding to the image data from the signal processing unit 14 as a so-called through image. For example, the output unit 15 includes a driver (not illustrated) driving a recording medium such as a semiconductor memory, a magnetic disk, and an optical disk, and records the image data from the signal processing unit 14 in a recording medium. For example, the output unit 15 functions as a communication interface for performing communication with respect to an external device (not illustrated), and transmits the image data from the signal processing unit 14 to the external device in a wireless manner or a wired manner.

The control unit 16 controls each of the units of the imaging device 10 according to an operation or the like of a user.

<Configuration Example of Circuit of Imaging Element>

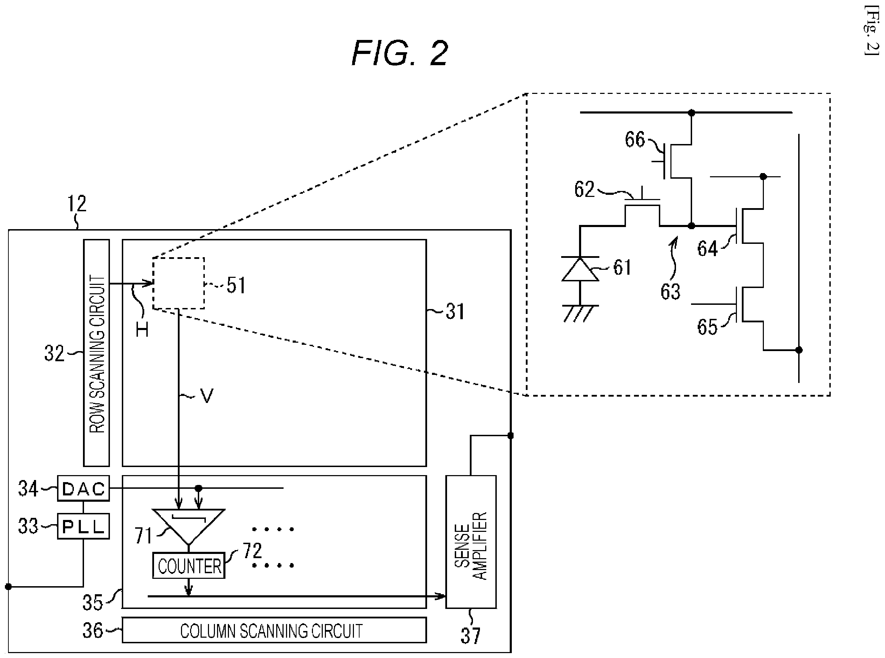

Fig. 2 is a block diagram illustrating a configuration example of a circuit of the imaging element 12 of Fig. 1.

The imaging element 12 includes a pixel array 31, a row scanning circuit 32, a phase locked loop (PLL) 33, a digital analog converter (DAC) 34, a column analog digital converter (ADC) circuit 35, a column scanning circuit 36, and a sense amplifier 37.

A plurality of pixels 51 are two-dimensionally arranged in the pixel array 31.

The pixel 51 includes a horizontal signal line H which is connected to the row scanning circuit 32, a photodiode 61 which is disposed in each point where the photodiode 61 intersects with a perpendicular signal line V connected to the column ADC circuit 35, and performs photoelectric conversion, and several types of transistors for reading out an accumulated signal. That is, the pixel 51, as enlargedly illustrated on the right side of Fig. 2, includes the photodiode 61, a transfer transistor 62, a floating diffusion 63, an amplification transistor 64, a selection transistor 65, and a reset transistor 66.

An electric charge accumulated in the photodiode 61 is transferred to the floating diffusion 63 through the transfer transistor 62. The floating diffusion 63 is connected to a gate of the amplification transistor 64. In a case where the pixel 51 is a target from which a signal is read out, the selection transistor 65 is turned on from the row scanning circuit 32 through the horizontal signal line H, and the amplification transistor 64 is subjected to source follower driving according to the signal of the selected pixel 51, and thus, the signal is read out to the perpendicular signal line V as a pixel signal corresponding to an accumulation electric charge amount of the electric charge accumulated in the photodiode 61. In addition, the pixel signal is reset by turning on the reset transistor 66.

The row scanning circuit 32 sequentially outputs a driving (for example, transferring, selecting, resetting, or the like) signal for driving the pixel 51 of the pixel array 31 for each row.

The PLL 33 generates and outputs a clock signal of a predetermined frequency which is necessary for driving each of the units of the imaging element 12, on the basis of the clock signal supplied from the outside.

The DAC 34 generates and outputs a lamp signal in the shape of being returned to a predetermined voltage value after a voltage drops from a predetermined voltage value at a certain slope (in the shape of approximately a saw).

The column ADC circuit 35 includes a comparator 71 and a counter 72 as many as the number corresponding to the number of columns of the pixel 51 of the pixel array 31, extracts a signal level from the pixel signal output from the pixel 51 by a correlated double sampling (CDS) operation, and outputs pixel data. That is, the comparator 71 compares the lamp signal supplied from the DAC 34 with the pixel signal (a brightness value) output from the pixel 51, and supplies a comparison result signal obtained as the result thereof to the counter 72. Then, the counter 72 counts a counter clock signal of a predetermined frequency according to the comparison result signal output from the comparator 71, and thus, the pixel signal is subjected to A/D conversion.

The column scanning circuit 36 sequentially supplies a signal of outputting the pixel data to the counter 72 of the column ADC circuit 35 at a predetermined timing.

The sense amplifier 37 amplifies the pixel data which is supplied from the column ADC circuit 35, and outputs the pixel data to the outside of the imaging element 12.

<First Embodiment of Imaging Element>

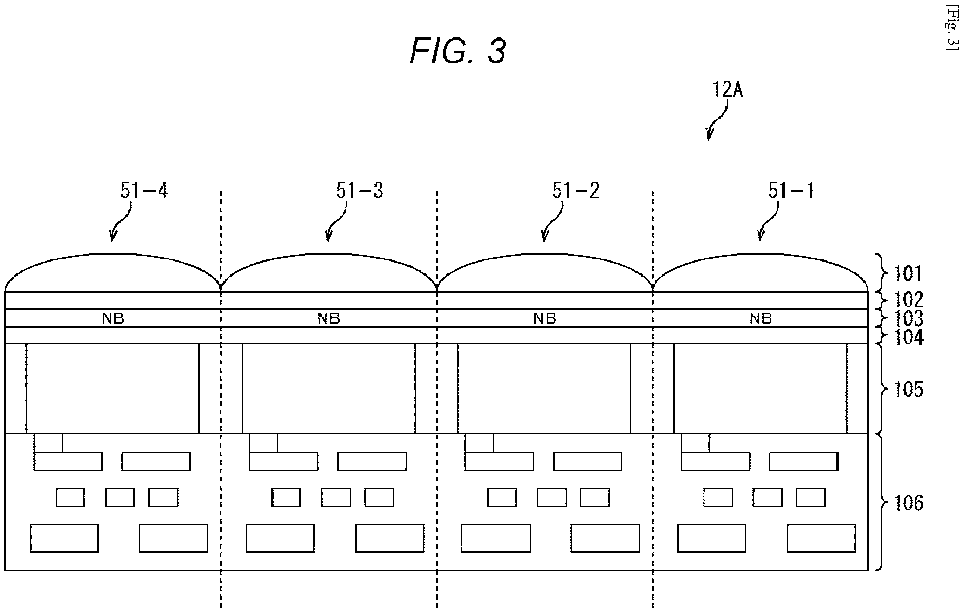

Fig. 3 schematically illustrates a configuration example of a sectional surface of an imaging element 12A, which is a first embodiment of the imaging element 12 of Fig. 1. Fig. 3 illustrates sectional surfaces of four pixels of a pixel 51-1 to a pixel 51-4 of the imaging element 12. Furthermore, hereinafter, in a case where it is not necessary to distinguish the pixel 51-1 to the pixel 51-4 from each other, the pixel will be simply referred to as the pixel 51.

An on-chip microlens 101, an interlayer film 102, a narrow band filter layer 103, an interlayer film 104, a photoelectric conversion element layer 105, and a signal wiring layer 106 are laminated in each of the pixels 51, in this order from the above. That is, the imaging element 12 is formed of a back-side illumination type CMOS image sensor in which the photoelectric conversion element layer 105 is disposed on an incident side of light from the signal wiring layer 106.

The on-chip microlens 101 is an optical element for condensing light into the photoelectric conversion element layer 105 of each of the pixels 51.

The interlayer film 102 and the interlayer film 104 are formed of a dielectric body such as SiO2. As described below, it is desirable that dielectric constants of the interlayer film 102 and the interlayer film 104 are as low as possible.

In the narrow band filter layer 103, a narrow band filter NB, which is an optical filter transmitting narrow band light in a predetermined narrow wavelength band (a narrow band), is disposed in each of the pixels 51. For example, a plasmon filter using front plasmon, which is one type of metal thin film filters using a thin film formed of a metal such as aluminum, is used in the narrow band filter NB. In addition, a transmission band of the narrow band filter NB is set for each of the pixels 51. The type (the number of bands) of the transmission band of the narrow band filter NB is arbitrary, and for example, the number of bands is set to be greater than or equal to 4.

Here, the narrow band, for example, is a wavelength band which is narrower than a transmission band of a color filter of the related art of red (R), green (G), and blue (B) or yellow (Y), magenta (M), and cyan (C), based on three primary colors or a color-matching function. In addition, hereinafter, a pixel receiving the narrow band light transmitted through the narrow band filter NB will be referred to as a multispectral pixel or a MS pixel.

The photoelectric conversion element layer 105, for example, includes the photodiode 61 or the like of Fig. 2, receives the light transmitted through the narrow band filter layer 103 (the narrow band filter NB) (the narrow band light), and converts the received light into an electric charge. In addition, the photoelectric conversion element layer 105 is configured such that the pixels 51 are electrically separated from each other by an element separating layer.

Wiring or the like for reading the electric charge which is accumulated in the photoelectric conversion element layer 105 is disposed on the signal wiring layer 106.

<Plasmon Filter>

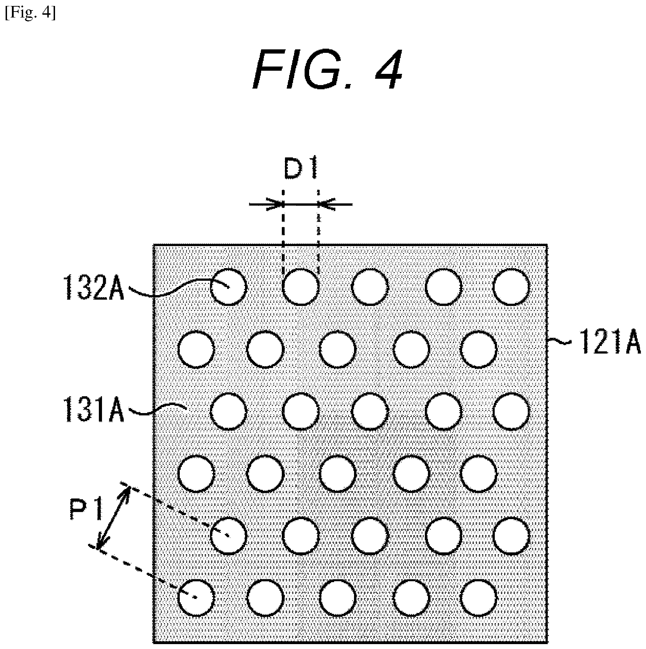

Next, the plasmon filter which can be used in the narrow band filter NB will be described with reference to Figs. 4 to 15.

Fig. 4 illustrates a configuration example of a plasmon filter 121A having a pore array structure.

The plasmon filter 121A is configured of a plasmon resonator in which holes 132A are arranged in a metal thin film (hereinafter, referred to as a conductor thin film) 131A in the shape of a honeycomb.

Each of the holes 132A penetrates through the conductor thin film 131A, and functions as a waveguide. In general, the waveguide has a cutoff frequency and a cutoff wavelength which are determined according to a shape such as a length of a side or a diameter, and has properties of not allowing light of a frequency less than or equal to the cutoff frequency (a wavelength less than or equal to the cutoff wavelength) to propagate. A cutoff wavelength of the hole 132A mainly depends on an opening diameter D1, and the cutoff wavelength shortens as the opening diameter D1 decreases.

Furthermore, the opening diameter D1 is set to a value which is smaller than the wavelength of the transmitted light.

On the other hand, in a case where light is incident on the conductor thin film 131A in which holes 132A are periodically formed during a short period less than or equal to the wavelength of the light, a phenomenon occurs in which light at a wavelength which is longer than the cutoff wavelength of the hole 132A is transmitted. Such a phenomenon will be referred to as an abnormal transmission phenomenon of the plasmon. Such a phenomenon occurs due to the excitation of front plasmon on a boundary between the conductor thin film 131A and the interlayer film 102, which is an upper layer of the conductor thin film 131A.

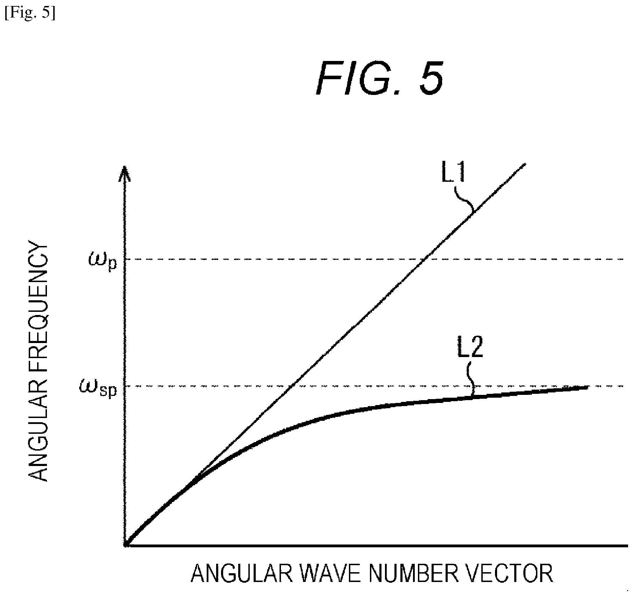

Here, occurrence conditions of the abnormal transmission phenomenon of the plasmon (a front plasmon resonance) will be described with reference to Fig. 5.

Fig. 5 is a graph illustrating a dispersion relationship of the front plasmon. In the graph, a horizontal axis represents an angular wave number vector k, and a vertical axis represents an angular frequency $\omega$. $\omega$p represents a plasma frequency of the conductor thin film 131A. $\omega$sp represents a front plasma frequency on a boundary surface between the interlayer film 102 and the conductor thin film 131A, and is represented by formula (1) described below.

[Math.1]

$$\omega_{sp} = \frac{\omega_p}{\sqrt{1 + \varepsilon_d}} \qquad \cdots (1)$$

$\varepsilon$d represents a dielectric constant of a dielectric body configuring the interlayer film 102.

According to formula (1), the front plasma frequency $\omega$sp increases as the plasma frequency $\omega$p increases. In addition, the front plasma frequency $\omega$sp increases as the dielectric constant $\varepsilon$d decreases.

A line L1 represents a dispersion relationship of the light (a write line), and is represented by formula (2) described below.

[Math.2]

$$\omega = \frac{c}{\sqrt{\varepsilon_d}} k \qquad \cdots (2)$$

c represents a light speed.

A line L2 represents a dispersion relationship of the front plasmon, and is represented by formula (3) described below.

[Math.3]

$$\omega = ck \sqrt{\frac{\varepsilon_m + \varepsilon_d}{\varepsilon_m \varepsilon_d}} \qquad \cdots (3)$$

$\varepsilon$m represents a dielectric constant of the conductor thin film 131A.

The dispersion relationship of the front plasmon represented by the line L2 is close to the write line represented by the line L1 in a range where the angular wave number vector k is small, and is close to the front plasma frequency $\omega$sp as the angular wave number vector k increases.

Then, when formula (4) described below is established, the abnormal transmission phenomenon of the plasmon occurs.

[Math.4]

$$Re \left[ \frac{\omega_{sp}}{c} \sqrt{\frac{\varepsilon_m \varepsilon_d}{\varepsilon_m + \varepsilon_d}} \right] = \left| \frac{2\pi}{\lambda} \sin\theta + iG_x + jG_y \right| \qquad \cdots (4)$$

$\lambda$ represents the wavelength of the incident light. $\theta$ represents an incident angle of the incident light. Gx and Gy are represented by formula (5) described below.

$$|Gx| = |Gy| = 2\pi/a0 ...(5)$$

a0 represents a lattice constant of a pore array structure formed of the hole 132A of the conductor thin film 131A.

In formula (4), the left member represents an angular wave number vector of the front plasmon, and the right member represents an angular wave number vector of the conductor thin film 131A during a pore array period. Accordingly, when the angular wave number vector of the front plasmon is identical to the angular wave number vector of the conductor thin film 131A during the pore array period, the abnormal transmission phenomenon of the plasmon occurs. Then, at this time, the value of $\lambda$ is a resonance wavelength of the plasmon (the transmission wavelength of the plasmon filter 121A).

Furthermore, in formula (4), the angular wave number vector of the front plasmon in the left member is determined according to the dielectric constant $\varepsilon m$ of the conductor thin film 131A and the dielectric constant $\varepsilon d$ of the interlayer film 102. On the other hand, the angular wave number vector during the pore array period in the right member is determined according to the incident angle $\theta$ of the light and a pitch (a hole pitch) P1 between the adjacent holes 132A of the conductor thin film 131A. Accordingly, the resonance wavelength and the resonance frequency of the plasmon are determined according to the dielectric constant $\varepsilon m$ of the conductor thin film 131A, the dielectric constant $\varepsilon d$ of the interlayer film 102, the incident angle $\theta$ of the light, and the hole pitch P1. Furthermore, in a case where the incident angle of the light is 0°, the resonance wavelength and the resonance frequency of the plasmon are determined according to the dielectric constant $\varepsilon m$ of the conductor thin film 131A, the dielectric constant $\varepsilon d$ of the interlayer film 102, and the hole pitch P1.

Accordingly, the transmission band of the plasmon filter 121A (the resonance wavelength of the plasmon) is changed according to a material and a film thickness of the conductor thin film 131A, a material and a film thickness of the interlayer film 102, a pattern period of the pore array (for example, the opening diameter D1 and the hole pitch P1 of the hole 132A), and the like. In particular, in a case where the material and the film thickness of the conductor thin film 131A and the interlayer film 102 are determined, the transmission band of the plasmon filter 121A is changed according to the pattern period of the pore array, in particular, the hole pitch P1. That is, the transmission band of the plasmon filter 121A is shifted to a short wavelength side as the hole pitch P1 narrows, and the transmission band of the plasmon filter 121A is shifted to a long wavelength side as the hole pitch P1 widens.

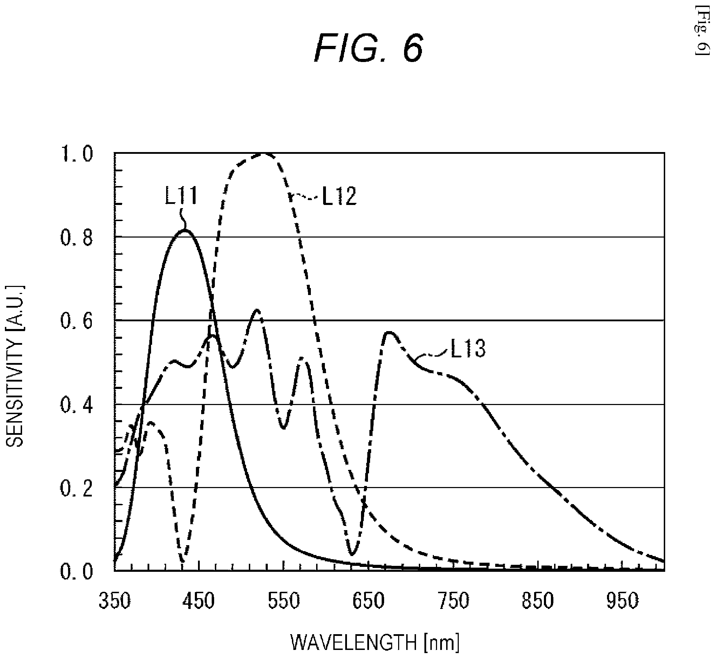

Fig. 6 is a graph illustrating an example of spectral characteristics of the plasmon filter 121A in a case where the hole pitch P1 is changed. In the graph, a horizontal axis represents a wavelength (the unit is nm), and a vertical axis represents sensitivity (the unit is an arbitrary unit). A line L11 represents spectral characteristics in a case where the hole pitch P1 is set to 250 nm, a line L12 represents spectral characteristics in a case where the hole pitch P1 is set to 325 nm, and a line L13 represents spectral characteristics in a case where the hole pitch P1 is set to 500 nm.

In a case where the hole pitch P1 is set to 250 nm, the plasmon filter 121A mainly transmits light in a wavelength band of a blue color. In a case where the hole pitch P1 is set to 325 nm, the plasmon filter 121A mainly transmits light in a wavelength band of a green color. In a case where the hole pitch P1 is set to 500 nm, the plasmon filter 121A mainly transmits light in a wavelength band of a red color. However, in a case where the hole pitch P1 is set to 500 nm, the plasmon filter 121A transmits a great amount of light in a low wavelength band of a red color according to a waveguide mode described below.

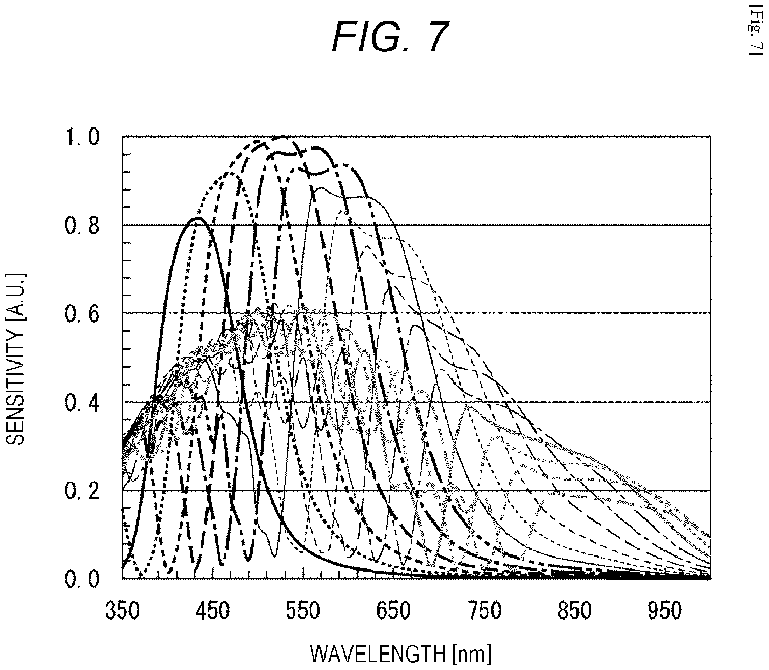

Fig. 7 is a graph illustrating another example of the spectral characteristics of the plasmon filter 121A in a case where the hole pitch P1 is changed. In the graph, a horizontal axis represents a wavelength (the unit is nm), and a vertical axis represents sensitivity (the unit is an arbitrary unit). This example illustrates an example of spectral characteristics of sixteen types of plasmon filters 121A in a case where the hole pitch P1 is changed by being divided by 25 nm from 250 nm to 625 nm.

Furthermore, the transmittance of the plasmon filter 121A is mainly determined according to the opening diameter D1 of the hole 132A. The transmittance increases as the opening diameter D1 increases, but color mixture easily occurs. In general, it is desirable that the opening diameter D1 is set such that an opening rate is 50% to 60% of the hole pitch P1.

In addition, as described above, each of the holes 132A of the plasmon filter 121A functions as a waveguide. Accordingly, in the spectral characteristics, there is a case where not only a wavelength component transmitted by the front plasmon resonance (a wavelength component in a plasmon mode) but also a wavelength component transmitted through the hole 132A (the waveguide) (a wavelength component in a waveguide mode) increases, according to a pattern of the pore array of the plasmon filter 121A.

For a given hole pitch P1 of the plasmon filter there is a range of desirable thicknesses of the plasmon filter to maximize light transmittance of the filter for those wavelengths that are transmitted. For instance, a range of desirable thicknesses of the plasmon filter may range between 20% and 80% of the size of the hole pitch P1, or between 30% and 70% of the size of the hole pitch, or between 40% and 60% of the size of the hole pitch.

For example, in a case where the plasmon filter is formed from Aluminum, a desirable range of thicknesses of the plasmon filter for a 350nm hole pitch is between 100nm and 300nm, with a preferred thickness of 200nm. For an Aluminum plasmon filter with a 550nm hole pitch, a desirable range of thicknesses of the plasmon filter is between 200nm and 400nm, with a preferred thickness of 300nm.

For a given peak transmission wavelength of the plasmon filter there is a range of desirable thicknesses of the plasmon filter to maximize light transmittance of the filter for those wavelengths that are transmitted. For instance, a range of desirable thicknesses of the plasmon filter may range between 10% and 60% of the peak transmission wavelength, or between 20% and 50% of the peak transmission wavelength, or between 30% and 40% of the peak transmission wavelength.

For example, in a case where the plasmon filter is formed from Aluminum, a desirable range of thicknesses of the plasmon filter when desirable a peak transmission wavelength of 580nm is between 100nm and 300nm, with a preferred thickness of 200nm. For an Aluminum plasmon filter with a peak transmission wavelength of 700nm, a desirable range of thicknesses of the plasmon filter is between 150nm and 350nm, with a preferred thickness of 250nm.

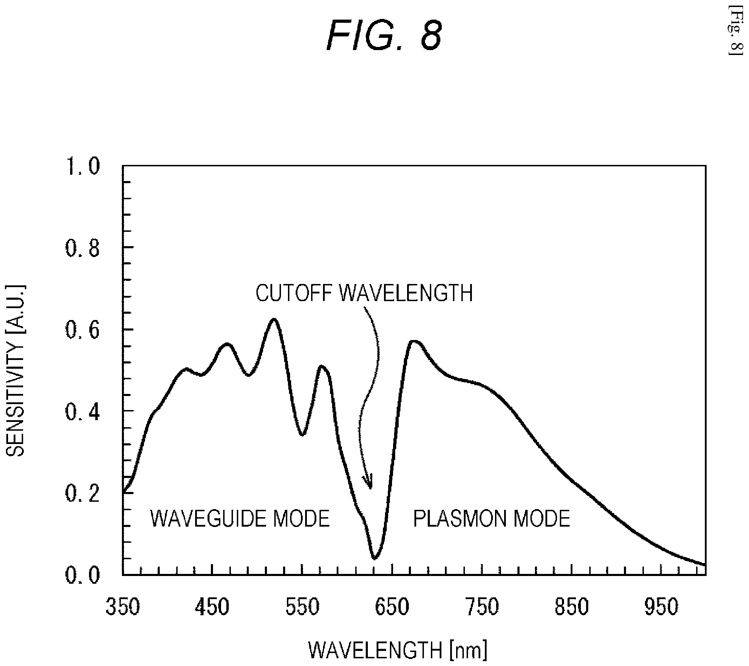

Fig. 8 illustrates the spectral characteristics of the plasmon filter 121A in a case where the hole pitch P1 is set to 500 nm, as with the spectral characteristics represented by the line L13 of Fig. 6. In this example, a wavelength side which is longer than the cutoff wavelength in the vicinity of 630 nm is the wavelength component in the plasmon mode, and a wavelength side which is shorter than the cutoff wavelength is the wavelength component in the waveguide mode.

As described above, the cutoff wavelength mainly depends on the opening diameter D1 of the hole 132A, and the cutoff wavelength decreases as the opening diameter D1 decreases. Then, wavelength resolution characteristics of the plasmon filter 121A are improved as a difference between the cutoff wavelength and the peak wavelength in the plasmon mode increases.

In addition, as described above, the front plasma frequency $\omega$sp of the conductor thin film 131A increases as the plasma frequency $\omega$p of the conductor thin film 131A increases. In addition, the front plasma frequency $\omega$sp increases as the dielectric constant $\varepsilon$d of the interlayer film 102 decreases. Then, it is possible to set the resonance frequency of the plasmon to be higher as the front plasma frequency $\omega$sp increases, and to set the transmission band of the plasmon filter 121A (the resonance wavelength of the plasmon) to a shorter wavelength band.

Accordingly, in a case where a metal having a smaller plasma frequency $\omega$p is used in the conductor thin film 131A, it is possible to set the transmission band of the plasmon filter 121A to a shorter wavelength band. For example, aluminum, silver, gold, or the like is preferable as the metal. Here, in a case where the transmission band is set to a long wavelength band of infrared light or the like, copper or the like can also be used.

In addition, in a case where a dielectric body having a small dielectric constant $\varepsilon$d is used in the interlayer film 102, it is possible to set the transmission band of the plasmon filter 121A to a shorter wavelength band. For example, SiO2, Low-K, or the like is preferable as the dielectric body.

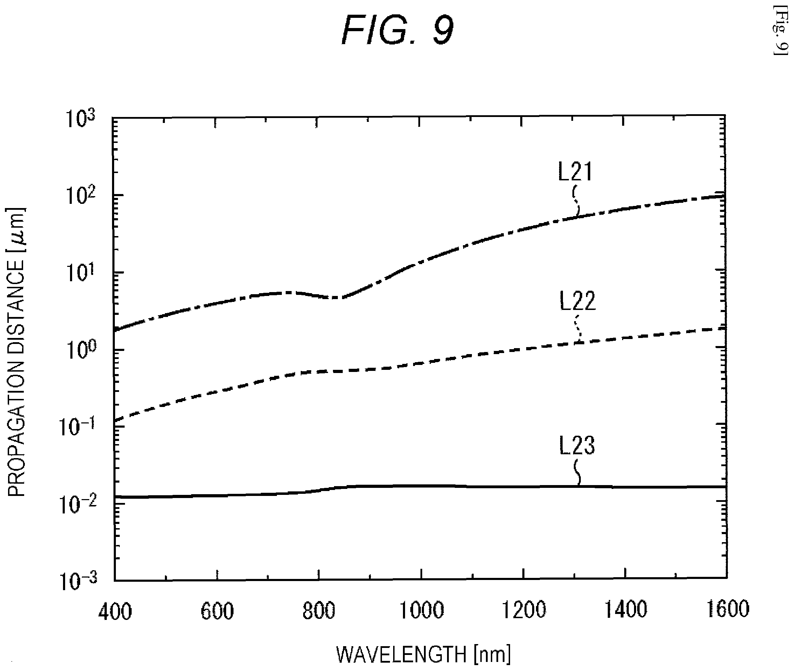

In addition, Fig. 9 is a graph illustrating propagation characteristics of the front plasmon on an interface between conductor thin film 131A and the interlayer film 102 in a case where aluminum is used in the conductor thin film 131A, and SiO2 is used in the interlayer film 102. In the graph, a horizontal axis represents the wavelength of the light (the unit is nm), and a vertical axis represents a propagation distance (the unit is $\mu$m). In addition, a line L21 represents propagation characteristics in an interface direction, a line L22 represents propagation characteristics in a depth direction of the interlayer film 102 (a direction perpendicular to the interface), and a line L23 represents propagation characteristics in a depth direction of the conductor thin film 131A (a direction perpendicular to the interface).

A propagation distance ASPP ($\lambda$) in a depth direction of the front plasmon is represented by formula (6) described below.

[Math.5]

$$\Lambda_{SPP}(\lambda) \equiv \frac{4\pi k_{SPP}}{\lambda} = \frac{4\pi}{\lambda} \, \text{Im}\left[\sqrt{\frac{\varepsilon_m \varepsilon_d}{\varepsilon_m + \varepsilon_d}}\right] \qquad \cdot \cdot \cdot (6)$$

kSPP represents an absorption coefficient of a substance propagated by the front plasmon. $\varepsilon$m ($\lambda$) represents a dielectric constant of the conductor thin film 131A with respect to light at a wavelength of $\lambda$. $\varepsilon$d ($\lambda$) represents a dielectric constant of the interlayer film 102 with respect to light at the wavelength of $\lambda$.

Accordingly, as illustrated in Fig. 9, front plasmon with respect to light at a wavelength of 400 nm propagates in the depth direction from a front surface of the interlayer film 102 formed of SiO2 to approximately 100 nm. Accordingly, the thickness of the interlayer film 102 is set to be greater than or equal to 100 nm, and thus, the front plasmon on the interface between the interlayer film 102 and the conductor thin film 131A is prevented from being affected by a substance laminated on a surface of the interlayer film 102 on a side opposite to the conductor thin film 131A.

In addition, front plasmon with respect to light at a wavelength of 400 nm propagates in the depth direction from a front surface of the conductor thin film 131A formed of aluminum to approximately 10 nm. Accordingly, the thickness of the conductor thin film 131A is set to be greater than or equal to 10 nm, and thus, the front plasmon on the interface between the interlayer film 102 and the conductor thin film 131A is prevented from being affected by the interlayer film 104.

<Other Examples of Plasmon Filter>

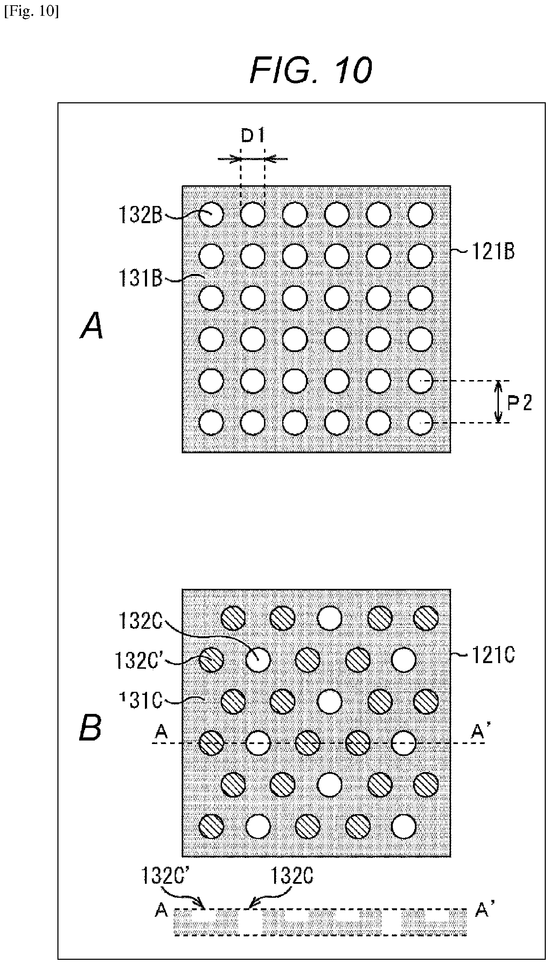

Next, other examples of the plasmon filter will be described with reference to Figs. 10A to 15.

A plasmon filter 121B of Fig. 10A is configured of a plasmon resonator in which holes 132B are arranged in a conductor thin film 131B in the shape of an orthogonal matrix. In the plasmon filter 121B, for example, a transmission band is changed according to a pitch P2 between adjacent holes 132B.

In addition, in the plasmon resonator, it is not necessary that all of the holes penetrate through the conductor thin film, and even in a case where a part of the holes is configured as a non-through which does not penetrate through the conductor thin film, the plasmon resonator functions as a filter.

For example, in Fig. 10B, a plan view and a sectional view (a sectional view taken along A-A' of the plan view) of a plasmon filter 121C configured of a plasmon resonator in which holes 132C formed of through holes and holes 132C' formed of non-through holes are arranged in the conductor thin film 131C in the shape of a honeycomb. That is, holes 132C formed of through holes and holes 132C' formed of non-through holes are periodically arranged in the plasmon filter 121C.

Further, a plasmon resonator of a single layer is basically used as the plasmon filter, and for example, the plasmon filter can be configured of a two-layer plasmon resonator.

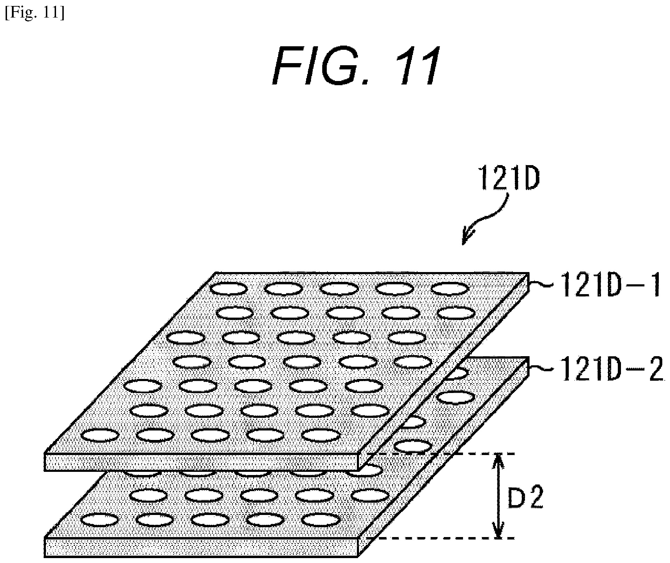

For example, a plasmon filter 121D illustrated in Fig. 11 is configured of two layers of a plasmon filter 121D-1 and a plasmon filter 121D-2. The plasmon filter 121D-1 and the plasmon filter 121D-2 have a structure in which holes are arranged in the shape of a honeycomb, as with the plasmon resonator configuring the plasmon filter 121A of Fig. 4.

In addition, it is preferable that an interval D2 between the plasmon filter 121D-1 and the plasmon filter 121D-2 is approximately 1/4 of a peak wavelength of a transmission band. In addition, in consideration of the freedom in design, it is preferable that the interval D2 is less than or equal to 1/2 of the peak wavelength of the transmission band.

Furthermore, as with the plasmon filter 121D, the holes are arranged in the same pattern in the plasmon filter 121D-1 and the plasmon filter 121D-2, and for example, the holes may be arranged in patterns similar to each other in a two-layer plasmon resonator structure. In addition, in the two-layer plasmon resonator structure, holes and dots may be arranged in a pattern in which a pore array structure and a dot array structure (described below) are inversed from each other. Further, the plasmon filter 121D has the two-layer structure, and is capable of being multilayered to be three or more layers.

In addition, in the above description, the configuration example of the plasmon filter using the plasmon resonator having the pore array structure has been described, but a plasmon resonator having a dot array structure may be adopted as the plasmon filter.

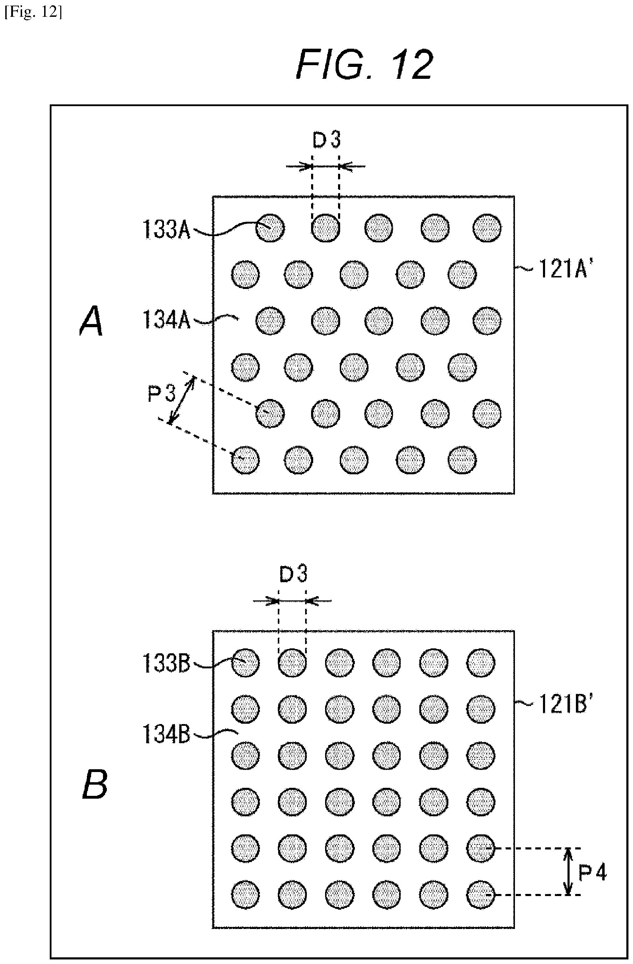

A plasmon filter having a dot array structure will be described with reference to Figs. 12A and 12B.

A plasmon filter 121A' of Fig. 12A has a structure which is negatively and positively inversed with respect to the plasmon resonator of the plasmon filter 121A of Fig. 4, that is, is configured of a plasmon resonator in which dots 133A are arranged in a dielectric layer 134A in the shape of a honeycomb. A space between the respective dots 133A is filled with the dielectric layer 134A.

The plasmon filter 121A' absorbs light in a predetermined wavelength band, and thus, is used as a complementary color filter. The wavelength band of the light which is absorbed by the plasmon filter 121A' (hereinafter, referred to as an absorption band) is changed according to a pitch (hereinafter, referred to as a dot pitch) P3 between the adjacent dots 133A. In addition, a diameter D3 of the dot 133A is adjusted according to the dot pitch P3.

A plasmon filter 121B' of Fig. 12B has a structure which is negatively and positively inversed with respect to the plasmon resonator of the plasmon filter 121B of Fig. 10A, that is, is configured of a plasmon resonator structure in which dots 133B are arranged in a dielectric layer 134B in the shape of an orthogonal matrix. A space between the respective dots 133B is filled with the dielectric layer 134B.

An absorption band of the plasmon filter 121B' is changed according to a dot pitch P4 or the like between the adjacent dots 133B. In addition, a diameter D3 of the dot 133B is adjusted according to the dot pitch P4.

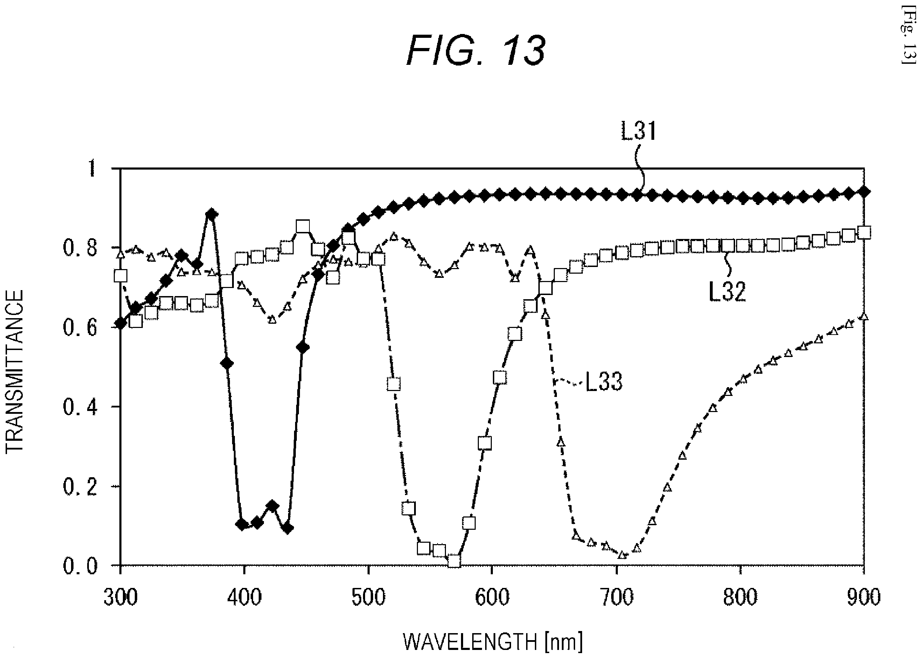

Fig. 13 is a graph illustrating an example of spectral characteristics in a case where the dot pitch P3 of the plasmon filter 121A' of Fig. 12A is changed. In the graph, a horizontal axis represents a wavelength (the unit is nm), and a vertical axis represents transmittance. A line L31 represents spectral characteristics in a case where the dot pitch P3 is set to 300 nm, a line L32 represents spectral characteristics in a case where the dot pitch P3 is set to 400 nm, and a line L33 represents spectral characteristics in a case where the dot pitch P3 is set to 500 nm.

As illustrated in the drawing, the absorption band of the plasmon filter 121A' is shifted to a short wavelength side as the dot pitch P3 narrows, and the absorption band of the plasmon filter 121A' is shifted to a long wavelength side as the dot pitch P3 widens.

Furthermore, in both of the plasmon filters having the pore array structure and the dot array structure, the transmission band or the absorption band can be adjusted by only adjusting the pitch between the holes or the dots in a planar direction. Accordingly, for example, the transmission band or the absorption band can be individually set with respect to each pixel by only adjusting the pitch between the holes or the dots in a lithography process, and the filter can be multicolored through a fewer process.

In addition, the thickness of the plasmon filter is approximately 100 nm to 500 nm, which is approximately similar to that of a color filter of an organic material, and a process affinity is excellent.

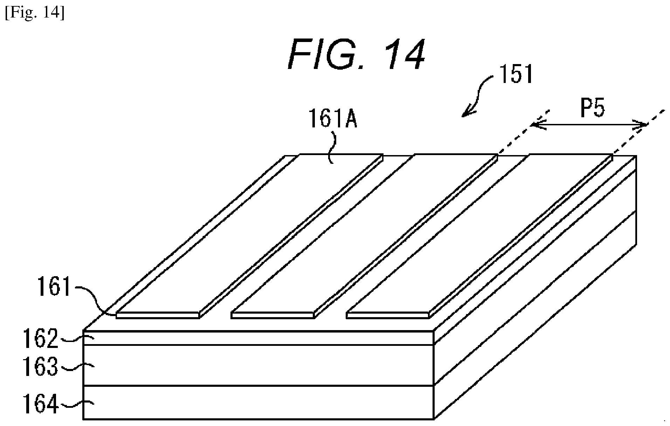

In addition, a plasmon filter 151 using a guided mode resonant (GMR) illustrated in Fig. 14 can also be used in the narrow band filter NB.

A conductor layer 161, an SiO2 film 162, an SiN film 163, and an SiO2 substrate 164 are laminated in the plasmon filter 151, in this order from the above. The conductor layer 161, for example, is included in the narrow band filter layer 103 of Fig. 3, and the SiO2 film 162, the SiN film 163, and the SiO2 substrate 164, for example, are included in the interlayer film 104 of Fig. 3.

For example, rectangular conductor thin films 161A formed of aluminum are arranged in the conductor layer 161 such that long sides of the conductor thin films 161A are adjacent to each other at a predetermined pitch P5. Then, a transmission band of the plasmon filter 151 is changed according to the pitch P5 or the like.

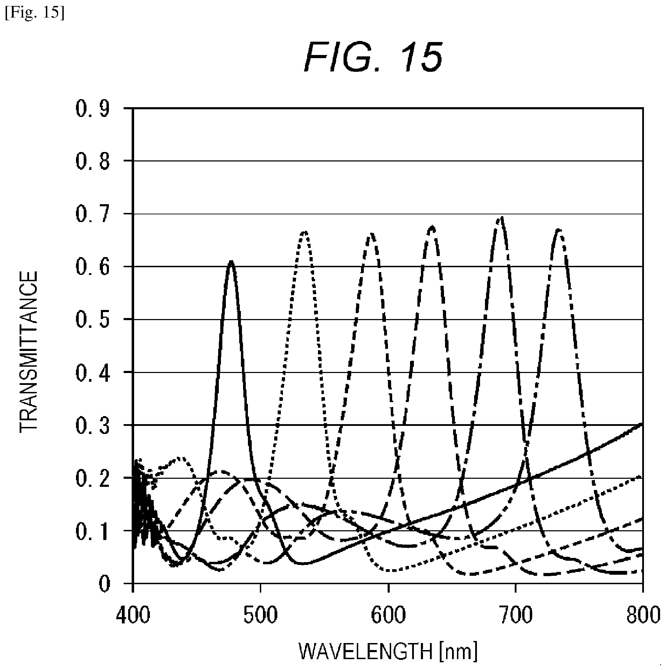

Fig. 15 is a graph illustrating an example of spectral characteristics of the plasmon filter 151 in a case where the pitch P5 is changed. In the graph, a horizontal axis represents a wavelength (the unit is nm), and a vertical axis represents transmittance. This example illustrates an example of spectral characteristics in a case where the pitch P5 is changed to six types of pitches by being divided by 40 nm from 280 nm to 480 nm, and a width of a slit between the adjacent conductor thin films 161A is set to be 1/4 of the pitch P5. In addition, a waveform having the shortest peak wavelength of the transmission band represents spectral characteristics in a case where the pitch P5 is set to 280 nm, and the peak wavelength elongates as the pitch P5 widens. That is, the transmission band of the plasmon filter 151 is shifted to a short wavelength side as the pitch P5 narrows, and the transmission band of the plasmon filter 151 is shifted to a long wavelength side as the pitch P5 widens.

The plasmon filter 151 using GMR has excellent affinity with respect to a color filter of an organic material, as with the plasmon filters having the pore array structure and the dot array structure described above.

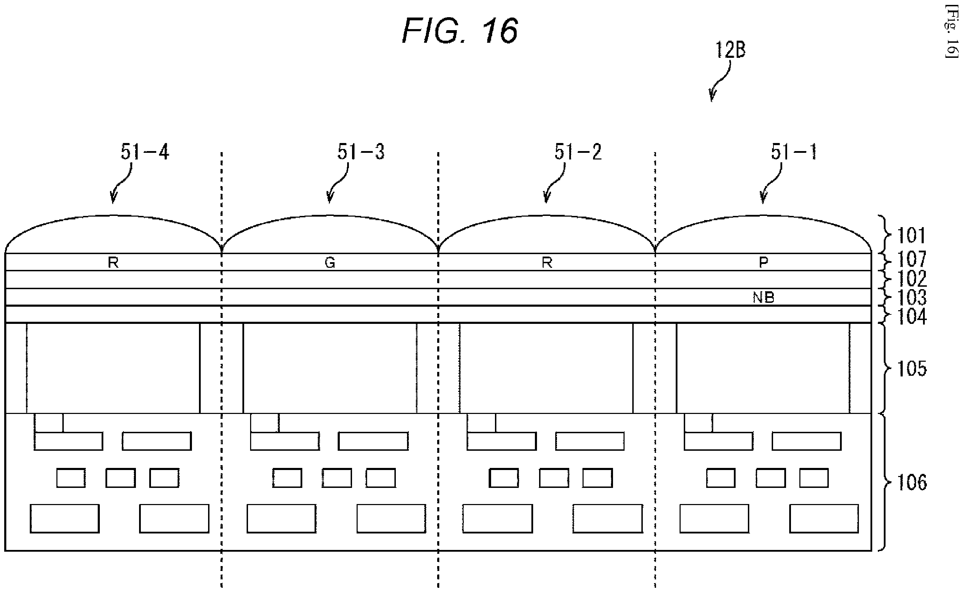

Next, the imaging element 12 of Fig. 1 will be described with reference to Figs. 16 to 21.

Fig. 16 schematically illustrates a configuration example of a sectional surface of an imaging element 112B. Furthermore, in the drawing, the same reference numerals are applied to portions corresponding to the imaging element 12A of Fig. 3, and the description thereof will be suitably omitted.

The imaging element 12B is different from the imaging element 12A in that a color filter layer 107 is laminated between the on-chip microlens 101 and the interlayer film 102.

In the narrow band filter layer 103 of the imaging element 12B, the narrow band filter NB is disposed in a part of the pixels 51 but not all of the pixels 51. The type of the transmission band of the narrow band filter NB (the number of bands) is arbitrary, and for example, the number of bands is set to be greater than or equal to 1.

In the color filter layer 107, a color filter is disposed in each of the pixels 51. For example, in the pixel 51 where the narrow band filter NB is not disposed, any one of a general red color filter R, a general green color filter G, and a general blue color filter B (not illustrated) is disposed. Accordingly, for example, an R pixel in which the red color filter R is disposed, a G pixel in which the green color filter G is disposed, a B pixel in which the blue color filter is disposed, and an MS pixel in which in which the narrow band filter NB is disposed, are arranged in the pixel array 31.

In addition, in the pixel 51 where the narrow band filter NB is disposed, a transmission filter P is disposed on the color filter layer 107. As described below, the transmission filter P is configured of an optical filter transmitting light in a wavelength band including the transmission band of the narrow band filter NB of the same pixel 51 (a low pass filter, a high pass filter, or a band pass filter).

Furthermore, the color filter disposed on the color filter layer 107 may be color filters of both of an organic material and an inorganic material.

Examples of the color filter of the organic material include a dyeing and coloring color filter of a synthetic resin or natural protein, and a color filter containing a dye using a pigment dye or a colorant dye.

Examples of the color filter of the inorganic material include materials such as TiO2, ZnS, SiN, MgF2, SiO2, and Low-k. In addition, for example, a method such as vapor deposition, sputtering, and chemical vapor deposition (CVD) film formation is used for forming the color filter of the inorganic material.

In addition, as described above with reference to Fig. 9, the interlayer film 102 is set to have a film thickness which is capable of preventing the influence of the color filter layer 107 on the front plasmon on an interface between the interlayer film 102 and the narrow band filter layer 103.

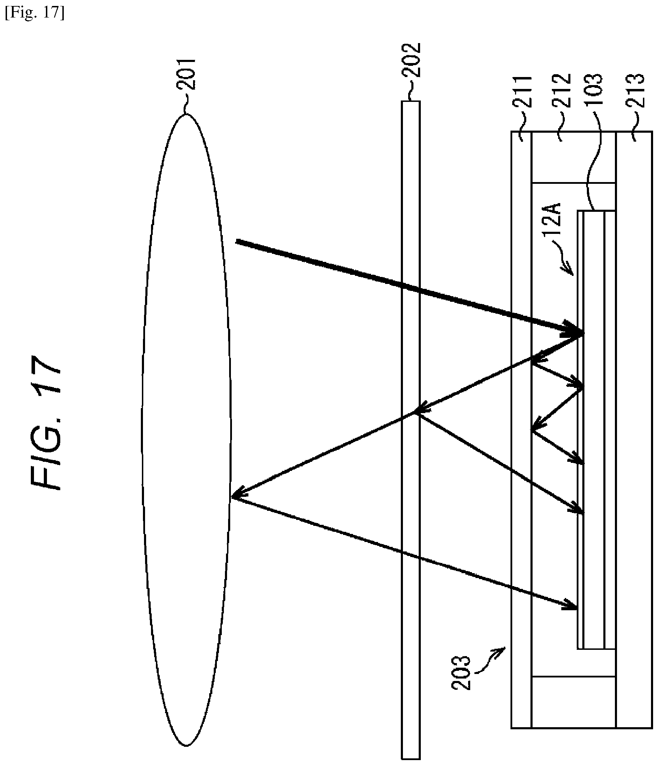

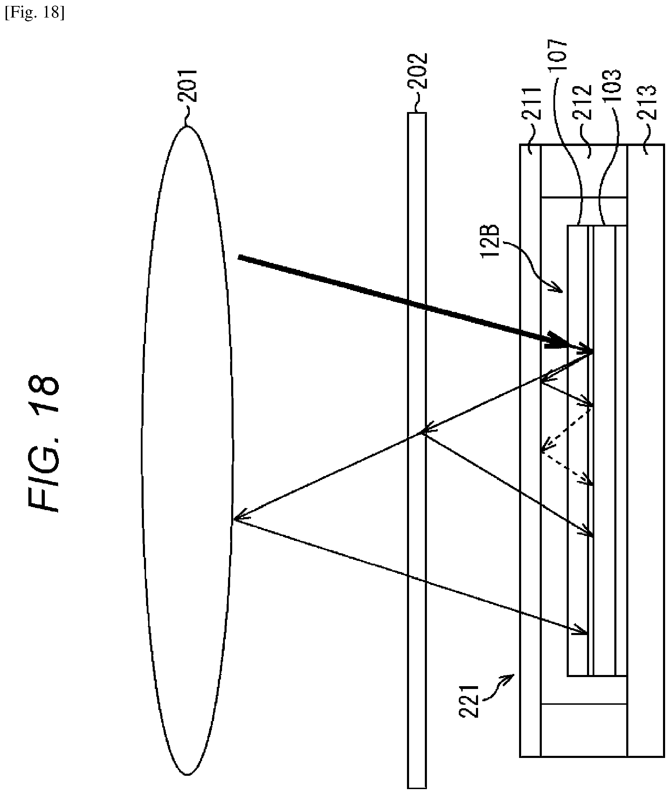

Here, the occurrence of flare is suppressed by the transmission filter P disposed on the color filter layer 107. This will be described with reference to Figs. 17 and 18.

Fig. 17 schematically illustrates an aspect of the occurrence of the flare of the imaging device 10 using the imaging element 12A of Fig. 2 in which the color filter layer 107 is not disposed.

In this example, the imaging element 12A is disposed on a semiconductor chip 203. Specifically, the semiconductor chip 203 is mounted on a substrate 213, and is surrounded by seal glass 211 and a resin 212. Then, light transmitted through a lens 201, an IR cut filter 202, and the seal glass 211, which are disposed in the optical system 11 of Fig. 1, is incident on the imaging element 12A.

Here, in a case where the narrow band filter NB of the narrow band filter layer 103 of the imaging element 12A is formed of a plasmon filter, a conductor thin film formed of metal is formed in the plasmon filter. The conductor thin film has a high reflection rate, and thus, light at a wavelength other than the transmission band is easily reflected. Then, a part of the light reflected on the conductor thin film, for example, as illustrated in Fig. 17, is reflected on the seal glass 211, the IR cut filter 202, or the lens 201, and is incident again on the imaging element 12A. The flare occurs due to the re-incident light. In particular, a plasmon filter using a pore array structure has a low opening rate, and thus, the flare easily occurs.

In order to prevent the reflection light, for example, it is considered that an antireflection film formed of a metal or a material having a high dielectric constant, which is different from the conductor thin film, is used. However, in a case where the plasmon filter uses a front plasmon resonance, and such an antireflection film is in contact with the front surface of the conductor thin film, there is a possibility that the characteristics of the plasmon filter are degraded, and desired characteristics are not obtained.

On the other hand, Fig. 18 schematically illustrates an aspect of the occurrence of the flare of the imaging device 10 using the imaging element 12B of Fig. 16, in which the color filter layer 107 is disposed. Furthermore, in the drawing, the same reference numerals are applied to portions corresponding to those of Fig. 17.

The example of Fig. 18 is different from the example of Fig. 17 in that a semiconductor chip 221 is disposed instead of the semiconductor chip 203. The semiconductor chip 221 is different from the semiconductor chip 203 in that the imaging element 12B is disposed instead of the imaging element 12A.

As described above, in the imaging element 12B, the transmission filter P is disposed on an upper side from the narrow band filter NB (an incident side of light). Accordingly, the light incident on the imaging element 12B is incident on the narrow band filter NB, in which a predetermined wavelength band is cutoff, by the transmission filter P, and thus, a light amount of the incident light with respect to the narrow band filter NB is suppressed. As a result thereof, a light amount of the reflection light on the conductor thin film of the narrow band filter NB (the plasmon filter) is also reduced, and thus, the flare is reduced.

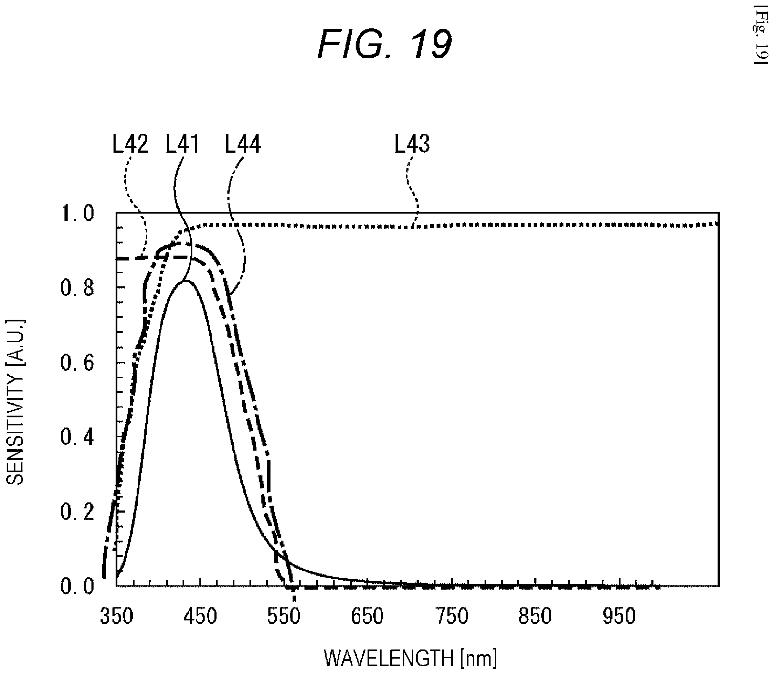

Figs. 19 to 21 illustrate examples of the spectral characteristics of the narrow band filter NB and the spectral characteristics of the transmission filter P disposed on the upper side of the narrow band filter NB. Furthermore, in the graphs of Figs. 19 to 21, a horizontal axis represents a wavelength (the unit is nm), and a vertical axis represents sensitivity (the unit is an arbitrary unit).

In Fig. 19, a line L41 represents the spectral characteristics of the narrow band filter NB. A peak wavelength of the spectral characteristics of the narrow band filter NB is approximately in the vicinity of 430 nm. A line L42 represents the spectral characteristics of a low pass type transmission filter P. A line L43 represents the spectral characteristics of a high pass type transmission filter P. A line L44 represents the spectral characteristics of a band pass type transmission filter P. The sensitivities of all of the transmission filters P are greater than the sensitivity of the narrow band filter NB in a predetermined wavelength band including the peak wavelength of the spectral characteristics of the narrow band filter NB. Accordingly, it is possible to reduce the light amount of the incident light which is incident on the narrow band filter NB without substantially attenuating the light in the transmission band of the narrow band filter NB, by using any transmission filter P.

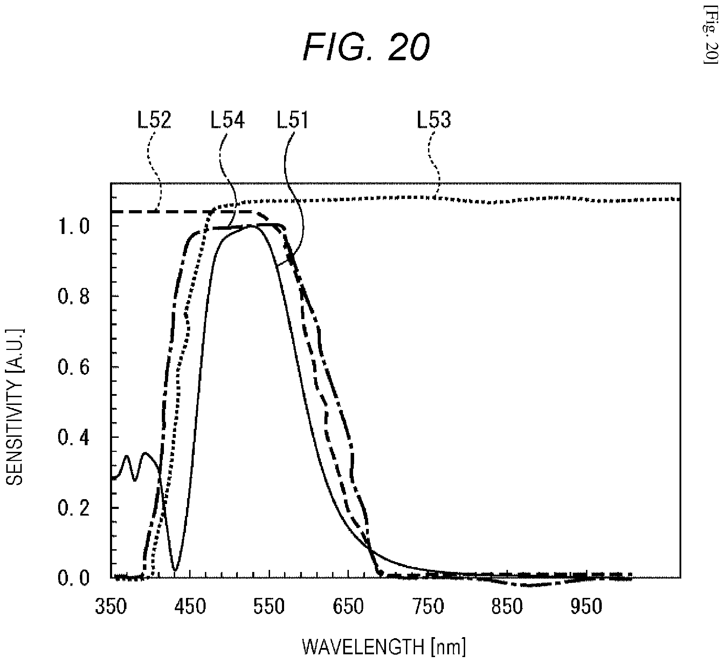

In Fig. 20, a line L51 represents the spectral characteristics of narrow band filter NB. A peak wavelength of the spectral characteristics of the narrow band filter NB is approximately in the vicinity of 530 nm. A line L52 represents the spectral characteristics of the low pass type transmission filter P. A line L53 represents the spectral characteristics of the high pass type transmission filter P. A line L54 represents the spectral characteristics of the band pass type transmission filter P. The sensitivities of all of the transmission filters are greater than the sensitivity of the narrow band filter NB in a predetermined wavelength band including the peak wavelength of the spectral characteristics of the narrow band filter NB. Accordingly, it is possible to reduce the light amount of the incident light which is incident on the narrow band filter NB without substantially attenuating the light in the transmission band of the narrow band filter NB, by using any transmission filter P.

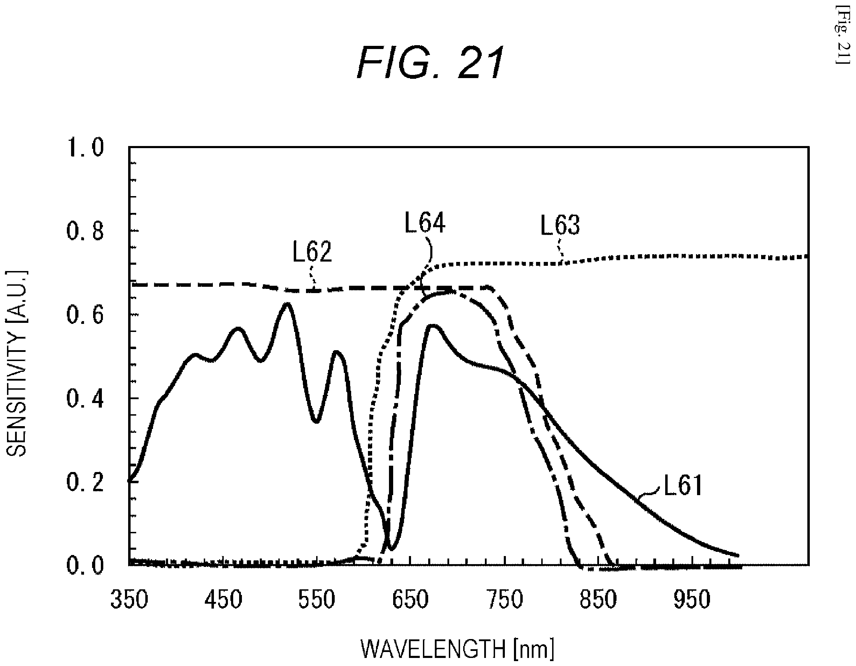

In Fig. 21, a line L61 represents the spectral characteristics of narrow band filter NB. A peak wavelength of the spectral characteristics of the narrow band filter NB in a plasmon mode is approximately in the vicinity of 670 nm. A line L62 represents the spectral characteristics of the low pass type transmission filter P. A line L63 represents the spectral characteristics of the high pass type transmission filter P. A line L64 represents the spectral characteristics of the band pass type transmission filter P. The sensitivities of all of the transmission filters are greater than the sensitivity of the narrow band filter NB in a predetermined wavelength band including the peak wavelength in the plasmon mode of greater than or equal to 630 nm, which is the cutoff wavelength of the spectral characteristics of the narrow band filter NB. Accordingly, it is possible to reduce the light amount of the incident light which is incident on the narrow band filter NB without substantially attenuating the light in the transmission band of the narrow band filter NB in the plasmon mode, by using any transmission filter P. Here, using the high pass type transmission filter P or the band pass type transmission filter P is desirable as the characteristics of a narrow band filter since light in a wavelength band of the narrow band filter NB in a waveguide mode can be cutoff.

Furthermore, in a case where the transmission band of the red color filter R, the green color filter G, or the blue color filter B includes a transmission band of the narrow band filter NB of a lower layer, such filters may be used in the transmission filter P.

In addition, in the example of Fig. 16, an example is described in which the narrow band filter NB is disposed only in a part of the pixels 51, and the narrow band filter NB is capable of being disposed in all of the pixels 51. In this case, in each of the pixels 51, the transmission filter P having a transmission band which includes the transmission band of the narrow band filter NB of the pixel 51 may be disposed on the color filter layer 107.

Further, a combination of the colors of the color filters in the color filter layer 107 is not limited to the example described above, and can be arbitrarily changed.

In addition, in a case where a countermeasure against the flare described above is not necessary, for example, the transmission filter P may be disposed on an upper layer of the narrow band filter NB, or a dummy filter transmitting light at all wavelengths may be disposed.

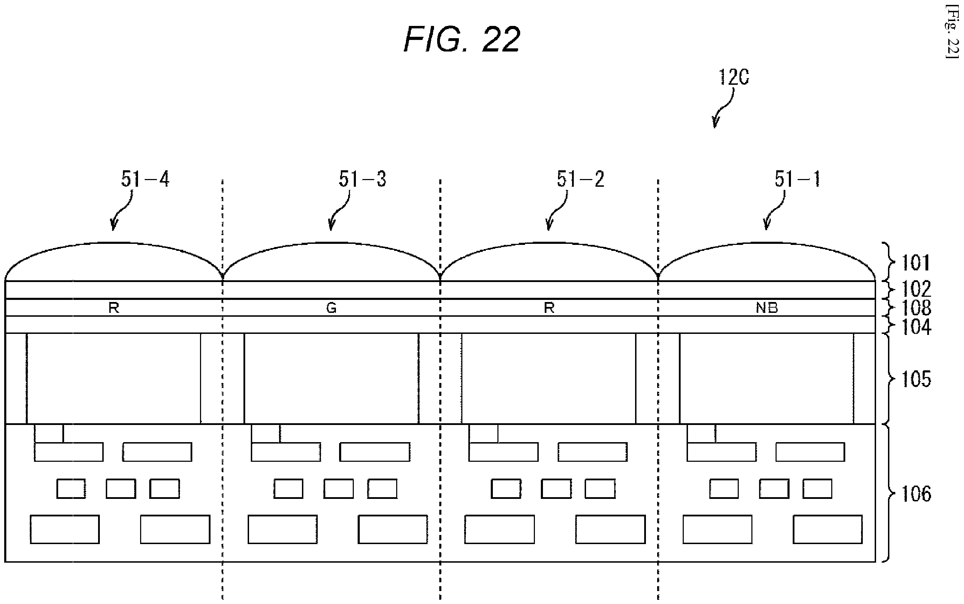

Next, the imaging element 12 of Fig. 1 will be described with reference to Fig. 22.

Fig. 22 schematically illustrates a configuration example of a sectional surface of an imaging element 12C. Furthermore, in the drawing, the same reference numerals are applied to portions corresponding to the imaging element 12A of Fig. 3, and the description thereof will be suitably omitted.

The imaging element 12C is different from the imaging element 12A in that a filter layer 108 is disposed instead of the narrow band filter layer 103. In addition, the imaging element 12C is different from the imaging element 12B of Fig. 16 in that the narrow band filter NB and the color filter (for example, the red color filter R, the green color filter G, and the blue color filter B) are disposed in the same filter layer 108.

Accordingly, in a case where the R pixel, the G pixel, the B pixel, and the MS pixel are arranged in the pixel array 31 of the imaging element 12C, the color filter layer 107 can be omitted.

Furthermore, in a case where the color filter of the organic material is used, in order to prevent a damage or the like of the color filter due to heat, for example, the narrow band filter NB is formed first, and final heat processing such as sinter processing is performed at a high temperature, and then, the color filter is formed. On the other hand, in a case where the color filter of the inorganic material is used, basically, there is no necessity to restrict the formation sequence described above.

In addition, in a case where the countermeasure against the flare is performed as in the imaging element 12B of Fig. 16, as with the imaging element 12B, the color filter layer may be laminated between the on-chip microlens 101 and the interlayer film 102. In this case, in the pixel 51 where the narrow band filter NB is disposed on the filter layer 108, the transmission filter P described above is disposed on the color filter layer. On the other hand, in the pixel 51 where the color filter is disposed on the filter layer 108, a filter may be disposed on the color filter layer, or a dummy filter transmitting light in all wavelengths or a color filter of the same color as that of the filter layer 108 may be disposed.

<Other shapes of Hole>

In the examples described above, for example, in the plasmon filter 121 described with reference to Figs. 10A and 10B, a case where the shape of the hole is a circular shape has been described as an example.

The shape of the hole is not limited to the circular shape, and may be other shapes. In addition, it is possible to change spectral characteristics by setting the shape of the hole to the other shape. In addition, it is possible to further change spectral characteristics (obtain desired spectral characteristics) by using the plasmon filter along with a polarizer.

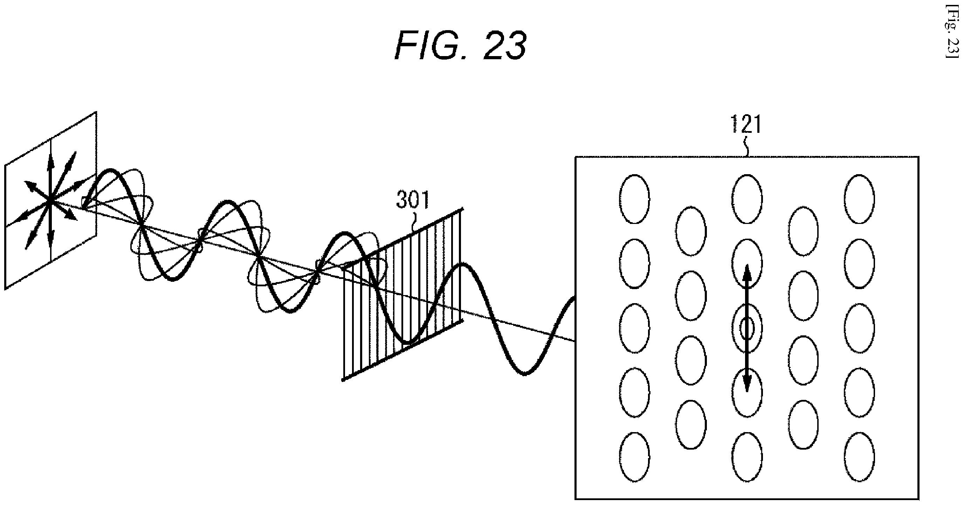

As illustrated in Fig. 23, light incident on a photoelectric conversion element (not illustrated) is incident through a polarizer 301 and a plasmon filter 121. Natural light is incident on the polarizer 301. The light has properties as a wave, and in the natural light such as solar light, a vibration direction (a vibration surface) is provided in which the wave vibrates in all directions of 360 degrees towards a traveling direction. Such natural light is incident on the polarizer 301.

The polarizer 301 is an optical element having properties in which the light vibrating in one specific direction is transmitted and light vibrating in the other direction is blocked. The natural light transmitted through the polarizer 301 is the light vibrating in one direction, that is, light having only one vibration surface that is polarized or linearly polarized light, and is supplied to the plasmon filter 121.

As described above, the plasmon filter 121 functions as a filter transmitting light at a predetermined frequency. The light transmitted through the plasmon filter 121 is light of a predetermined frequency component, and such light is received in a photodiode (not illustrated).

In the present invention, the shape of the hole of the plasmon filter 121 as illustrated in Fig. 23 is an elliptical shape. Thus, a shape of an uneven structure (the hole (a concave portion) or the dot (a convex portion), hereinafter, the hole will be described as an example) provided in the plasmon filter 121 at a predetermined periodic interval is an elliptical shape.

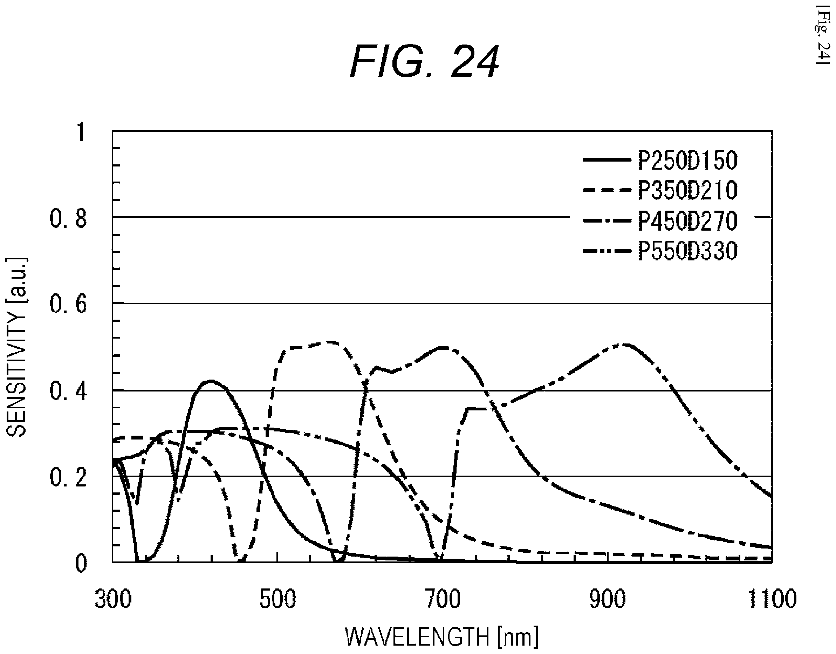

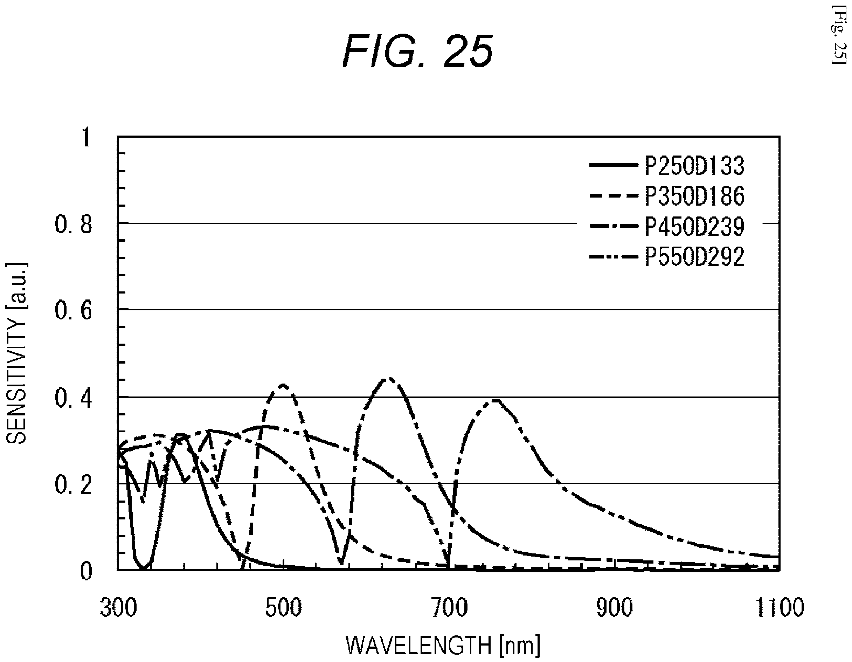

In the present invention, the shape of the hole of the plasmon filter 121 is set to the elliptical shape, and thus, it is possible to further improve spectral performance. In addition, according to a combination with the polarizer 301, it is possible to further improve the spectral performance. This will be described with reference to Figs. 24 and 25. In Figs. 24 and 25, a horizontal axis represents a wavelength, and a vertical axis represents sensitivity of the light received in the photodiode.

Fig. 24 illustrates a case where the shape of the hole of the plasmon filter 121 is the circular shape and Fig. 25 illustrates a case where the shape of the hole of the plasmon filter 121 is the elliptical shape, respectively.

In Fig. 24, a graph illustrated by a solid line represents a case of using the plasmon filter 121 in which a hole pitch P is 250 nm and an opening diameter D is 150 nm, a graph illustrated by a broken line represents a case of using the plasmon filter 121 in which the hole pitch P is 350 nm and the opening diameter D is 210 nm, a graph illustrated by a dashed-dotted line represents a case of using the plasmon filter 121 in which the hole pitch P is 450 nm and the opening diameter D is 270 nm, and a graph illustrated by a dashed-two dotted line represents a case of using the plasmon filter 121 in which the hole pitch P is 550 nm and the opening diameter D is 330 nm, respectively.

In Fig. 25, a graph illustrated by a solid line represents a case of using the plasmon filter 121 in which the hole pitch P is 250 nm and a long diameter of the opening diameter D is 133 nm, a graph illustrated by a broken line represents a case of using the plasmon filter 121 in which the hole pitch P is 350 nm and the long diameter of the opening diameter D is 186 nm, a graph illustrated by a dashed-dotted line represents a case of using the plasmon filter 121 in which the hole pitch P is 450 nm and the long diameter of the opening diameter D is 239 nm, and a graph illustrated by a dashed-two dotted line represents a case of using the plasmon filter 121 in which the hole pitch P is 550 nm and the long diameter of the opening diameter D is 292 nm, respectively. In addition, in the present invention, the ellipticity of an ellipse is 66.67%.

In addition, in the graphs of Figs. 24 and 25, a case is illustrated in which the thickness of the plasmon filter 121 is 150 nm, and aluminum (Al) is used as the material. In addition, a case is illustrated in which the same polarizer is used as the polarizer 301.

As described above, in the graphs illustrated in each of Figs. 24 and 25, results measured under the same conditions except for the shape of the hole of the plasmon filter 121 is the circular shape or the elliptical shape.

In the graph illustrated in Fig. 24 or Fig. 25, it is preferable that a peak is obtained at a targeted frequency, and a half width is small (a half width in a desired frequency band) as the spectral performance of the plasmon filter 121. That is, it is preferable that light in a frequency band based on the targeted frequency is selectively extracted.

In a case of comparing a short wavelength side and a long wavelength side with reference to Fig. 24, it is read that a half width is comparatively narrow, there is a peak, and light at a predetermined frequency band is capable of being selectively extracted, on the short wavelength side, but it is read that the half width is wide, and the light at the predetermined frequency band is not capable of being selectively extracted, on the long wavelength side.

In a case of comparing the short wavelength side and the long wavelength side with reference to Fig. 25, it is read that the half width is comparatively narrow, there is the peak, and the light at the predetermined frequency band is capable of being selectively extracted, on the short wavelength side. In addition, it is read that the half width is narrow, and the light at the predetermined frequency band is capable of being selectively extracted, on the long wavelength side.

That is, the shape of the hole of the plasmon filter 121 is set to the elliptical shape, and thus, it is read that the half width on the long wavelength side is improved, and the light at the targeted frequency band is capable of being selectively extracted.

With reference to Figs. 24 and 25, for example, in the graph illustrated by the broken line, a portion which is the peak in Fig. 24 is flat, but a portion which is the peak in Fig. 25 is precipitous. In addition, the half width of the graph illustrated by the broken line of Fig. 25 is narrower than the half width of the graph illustrated by the broken line of Fig. 24.

From this, the shape of the hole of the plasmon filter 121 is set to the elliptical shape, and thus, it is read that the half width becomes narrow, and the light at the targeted frequency band is capable of being selectively extracted, on the short wavelength side.

Thus, the shape of the hole of the plasmon filter 121 is set to the elliptical shape, and thus, the half width is improved, and the light at the targeted frequency band is capable of being more selectively extracted, on both of the short wavelength side and the long wavelength side.

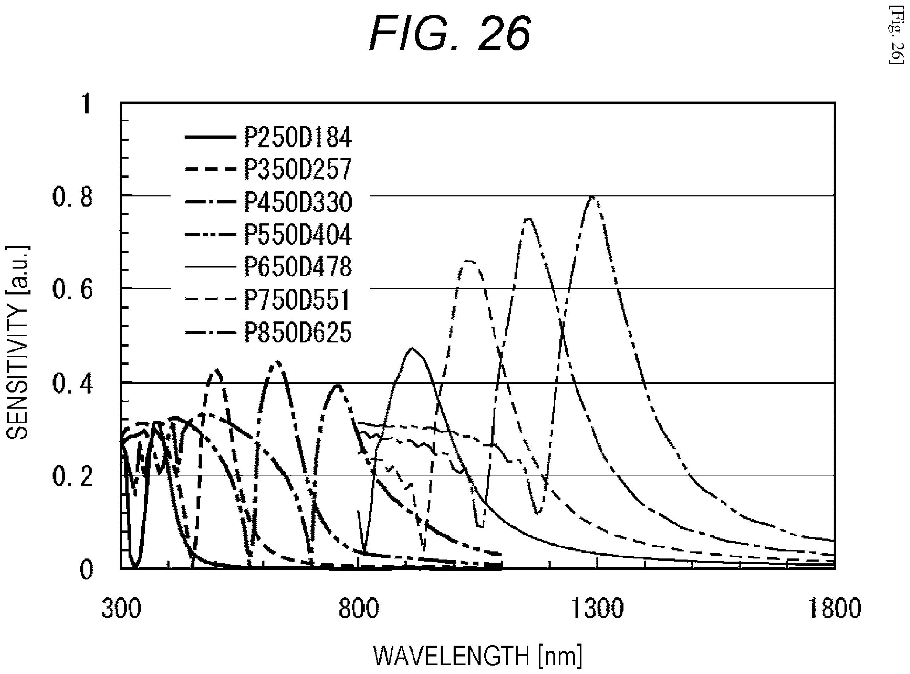

In addition, this applicant has further performed measurement using the plasmon filter 121 in which the shape of the hole is the elliptical shape with respect to the long wavelength side. Specifically, as illustrated in Fig. 26, the measurement was performed to a wavelength of 1800 nm (in Fig. 25, 1100 nm), and as a result thereof, a result was capable of being obtained in which the half width is narrow by using the targeted frequency as the peak, even in a frequency band of 1100 nm to 1800 nm, not illustrated in Fig. 25.

From this, the shape of the hole of the plasmon filter 121 is set to the elliptical shape, and thus, it is possible to allow the filter to cover light up to near infrared light.

Such characteristics can be obtained by setting the shape of the hole of the plasmon filter 121 to the elliptical shape, and the performance can be further improved by the combination with the polarizer 301.

In a case of combining the polarizer 301 with the plasmon filter 121 in which the shape of the hole is the elliptical shape, it is preferable that a direction of a polarization component from the polarizer 301 and a direction of a major axis of the ellipse of the plasmon filter 121 are the same direction. In other words, it is preferable that a transverse electric wave (TE wave) is coincident with a major axis direction of the ellipse.

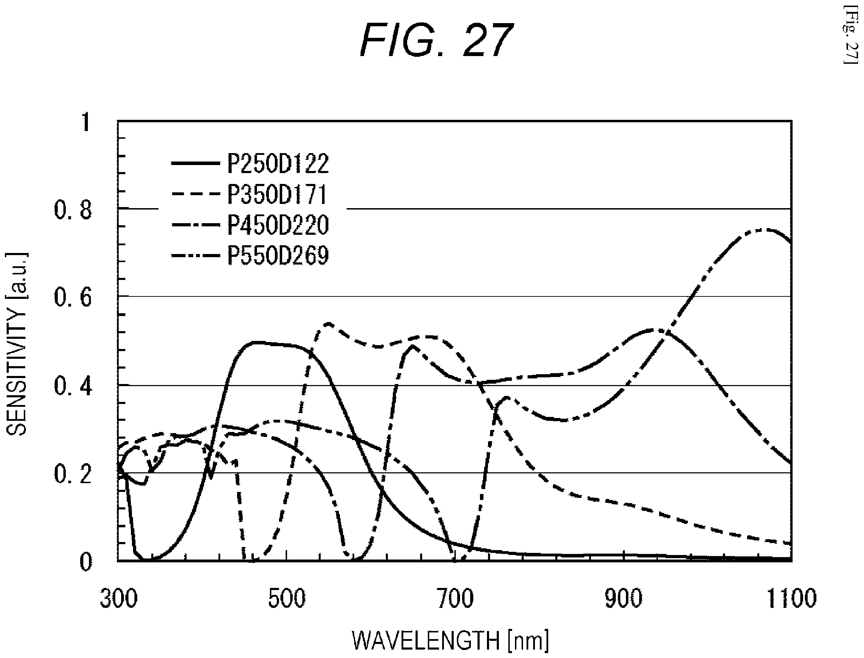

The graphs illustrated in Figs. 25 and 26 illustrate a measurement result in a case where the TE wave is coincident with the major axis direction of the ellipse. In contrast, Fig. 27 illustrates a measurement result in a case where the TE wave is not coincident with the major axis direction of the ellipse, but a transverse magnetic wave (TM wave) is coincident with the major axis direction of the ellipse.

The graph illustrated in Fig. 27 is a graph when the measurement is performed by using the polarizer 301 and the plasmon filter 121 at the time of obtaining the graph illustrated in Fig. 25, but is different in that the measurement is performed in a state where the TE wave is not coincident with the major axis direction of the ellipse.

With reference to the graph illustrated in Fig. 27, it is read that the half width on the long wavelength side becomes wide, and the shape of the hole illustrated in Fig. 24 is degraded compared to a case of the plasmon filter 121 with the circular shape. In addition, it is read that such degradation of the half width occurs in the entire wavelength band.

Thus, in a case where the TE wave is not coincident with the major axis direction of the ellipse, the selectivity of the light at the targeted frequency band is degraded, and thus, it is preferable that the TE wave is coincident with the major axis direction of the ellipse.

Furthermore, in a case of describing that a coincidence is high in a state where the TE wave is coincident with the major axis direction of the ellipse, in other words, a state where the direction of the polarization component from the polarizer 301 is coincident with the direction of the major axis of the ellipse of the plasmon filter 121, the coincidence is changed, and thus, the characteristics such as the half width may be adjusted.

For example, in a case where the direction of the polarization component from the polarizer 301 and the direction of the major axis of the ellipse of the plasmon filter 121 are slightly shifted, and the coincidence decreases, it is considered that the half width is wider than that of a state where the coincidence is high. The direction of the polarization component from the polarizer 301 or the direction of the major axis of the ellipse of the plasmon filter 121 is adjusted, and thus, a state can be obtained in which the coincidence is changed and a desired half width is obtained. For example, in a case of planning to extract a wide frequency band, the direction of the polarization component from the polarizer 301 and the direction of the major axis of the ellipse of the plasmon filter 121 can be arranged by being shifted such that the coincidence decreases.

In addition, focusing on the ellipticity, the graph of Fig. 24 illustrates a case where the ellipticity is 100%, the graph of Fig. 25 illustrates a case where the ellipticity is 66.67% (= short axis : major axis = 1 : 1.5) and the graph of Fig. 27 illustrates a case where the ellipticity is 150%. Accordingly, the ellipticity is changed from such results, and thus, the characteristics such as the half width may be adjusted.

Thus, the polarizer 301 is combined with the plasmon filter 121 in which the shape of the hole is the elliptical shape, and thus, it is possible to further increase the spectral performance.

In addition, the polarizer 301, the plasmon filter 121, or the combination between the polarizer 301 and the plasmon filter 121 is adjusted, and thus, it is possible to adjust a frequency (a frequency band) to be extracted. A portion to be adjusted increases, and thus, it is possible to extract a desired frequency with a more accuracy.

In the adjustment of the polarizer 301, as described below, the type of the polarizer is adjusted, and thus, it is possible to extract an electromagnetic wave at a predetermined frequency.

In addition, in the adjustment of the plasmon filter 121, as described above, the size of the hole (the long diameter and the short diameter), a distance between the holes (the hole pitch P), the thickness of the hole (a film thickness), and the like are adjusted, and thus, it is possible to extract the electromagnetic wave at the predetermined frequency. In addition, the shape of the hole of the plasmon filter 121 is set to a circular shape, an elliptical shape, and the like, and thus, it is possible to change the characteristics, and to extract the electromagnetic wave at the predetermined frequency.

Furthermore, the circular shape and the elliptical shape have been described as an example of the shape of the hole of the plasmon filter 121, but the shape of the hole of the plasmon filter 121 may be other shapes. For example, the shape of the hole of the plasmon filter 121 may be a polyangular shape such as a triangular shape and a quadrangular shape.

However, this applicant has measured the spectral characteristics in a case of a triangular shape or a quadrangular shape as the shape of the hole of the plasmon filter 121, and has confirmed that the half width is wide, and it is difficult to successfully extract a signal in the targeted frequency band.

Accordingly, in the present invention, it is considered that the elliptical shape is suitable in order to successfully extract the signal in the targeted frequency band, and the shape of the hole of the plasmon filter 121 is set to the elliptical shape with an ellipticity of 66,67%, and thus, it is possible to obtain the effect as described above.

<Polarizer>

The polarizer 301, for example, is used in a case of taking out linearly polarized light from arbitrary light. In this case, for example, a linear polarizer which absorbs and reflects light vibrating in a certain direction and light having a vibration direction orthogonal to the certain direction, is used.

For example, a wire grid type polarizer can be used as such a polarizer 301. The wire grid type polarizer 301 is a polarizer in which a fine metal grid (in the shape of a slit) is formed on a front surface of glass, and thus, a p polarization component is transmitted, and an s polarization component is reflected (partially absorbed), and therefore, polarization characteristics can be obtained.

In addition, a crystal type polarizer can be used as the polarizer 301. The crystal type polarizer 301 is a polarizer using a crystalline material such as mica or crystal, and is a polarizer which is capable of controlling a polarization component by using a birefringence phenomenon of the material itself.

In addition, a polarizer using a Glan-Thompson prism can be used as the polarizer 301. The polarizer 301 using the Glan-Thompson prism is a polarizer which combines prisms of calcite, which is a birefringence crystal, and is capable of removing a linear polarization component in one direction according to total reflection.

In addition, an inorganic absorption type polarizer can be used as the polarizer 301. The inorganic absorption type polarizer 301 is an element which produces the linearly polarized light in the element, and is a polarizer which is configured of an inorganic material, and thus, has characteristics in that heat resistance is excellent, and a scratch, degradation, or the like does not occur.

In addition, a resin type polarizer can be used as the polarizer 301. The resin type polarizer 301, for example, is a polarizer which is capable of being formed by stretching a film, in which a dichromatic dye such as iodine is impregnated in polyvinyl alcohol (PVA), in a certain direction, in the shape of a sheet, and has characteristics in that the price is comparatively inexpensive. In addition, a polarizer, in which a colorant is used instead of iodine, is used as the resin type polarizer 301.

In addition, a glass polarizer can be used as the polarizer 301. The glass polarizer is a polarizer which includes metal particles contained in the polarizer and is capable of using a phenomenon referred to as front surface plasmon absorption. The glass polarizer is a polarizer in which the metal particles allow light absorption to occur by coupling (resonating) an optical-electric field from a visible range to a near infrared range to plasmon, and thus, characteristics in that the light can be controlled by polarization are obtained by absorbing the energy of the light emitted to the polarizer on front surface plasmon.

The polarizers as described above can be used as the polarizer 301. Furthermore, the polarizer described above is an example, but is not limited thereto, and thus, a polarizer other than the polarizers described above may be applied to the polarizer 301 of the present technology.

The polarizer 301 is used by being combined with the plasmon filter 121, and thus, a polarizer which is optimized by being combined with the plasmon filter 121 is selected and used. For example, the polarizer 301 and the plasmon filter 121 are laminated at the time of forming the imaging element 12, and thus, the polarizer 301 suitable for the lamination is used.

<Configuration of Imaging Element 12>

As described above, the configuration of the imaging device 10 in a case where the polarizer 301 and the plasmon filter 121 are incorporated in the imaging element 12 will be described.

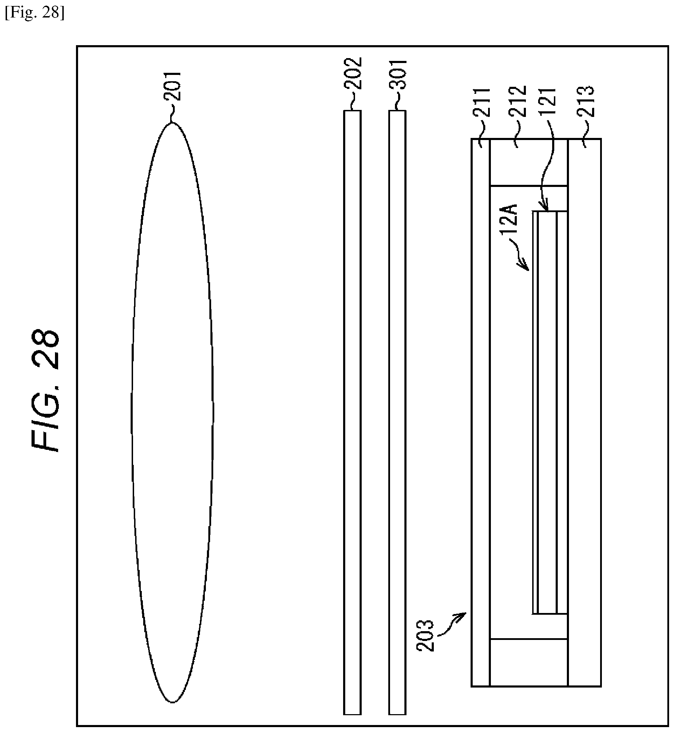

Fig. 28 is a diagram illustrating the configuration of an example of the imaging device 10 including the imaging element 12 in a case where, for example, the polarizer 301 is configured of a film in which iodine or a colorant is impregnated in a resin, in the polarizer 301 described above.

The configuration of the imaging device 10 illustrated in Fig. 28 and the configuration of the imaging device 10 illustrated in Fig. 17 are basically similar configurations, but the configuration of the imaging device 10 illustrated in Fig. 28 is different from the configuration of the imaging device 10 illustrated in Fig. 17 in that the polarizer 301 is added. In the imaging device 10 illustrated in Fig. 28, the polarizer 301 is disposed between an IR cut filter 202 and seal glass 211.

For example, the polarizer 301 is capable of being formed in the shape of a sheet, and the polarizer 301 formed in the shape of a sheet can be attached onto the seal glass 211.

Alternatively, even though it is not illustrated, a configuration may be used in which the polarizer 301 formed in the shape of a sheet is attached to the seal glass 211 on a semiconductor chip 203 side.

Alternatively, even though it is not illustrated, the polarizer 301 may be disposed in a portion other than the seal glass 211.

Furthermore, in the imaging element 12 illustrated in Fig. 28, a configuration is illustrated in which the IR cut filter 202 is disposed, but a configuration can be used in which the IR cut filter 202 is not disposed. In addition, the imaging device 10 illustrated in Fig. 28 has a configuration in which the polarizer 301 is disposed with respect to the imaging device 10 using the imaging element 12A in which the color filter layer 107 illustrated in Fig. 17 is not disposed, and is also capable of having a configuration in which the polarizer 301 is disposed with respect to the imaging device 10 using the imaging element 12B in which the color filter layer 107 illustrated in Fig. 18 is disposed.

In addition, the imaging device 10 illustrated in Fig. 28 has a configuration in which the seal glass 211 is disposed, but is capable of having a configuration in which the seal glass 211 is not disposed, and in such a configuration, the polarizer 301 can be attached onto the chip or other polarizers 301 such as a wire grid type polarizer can be disposed.

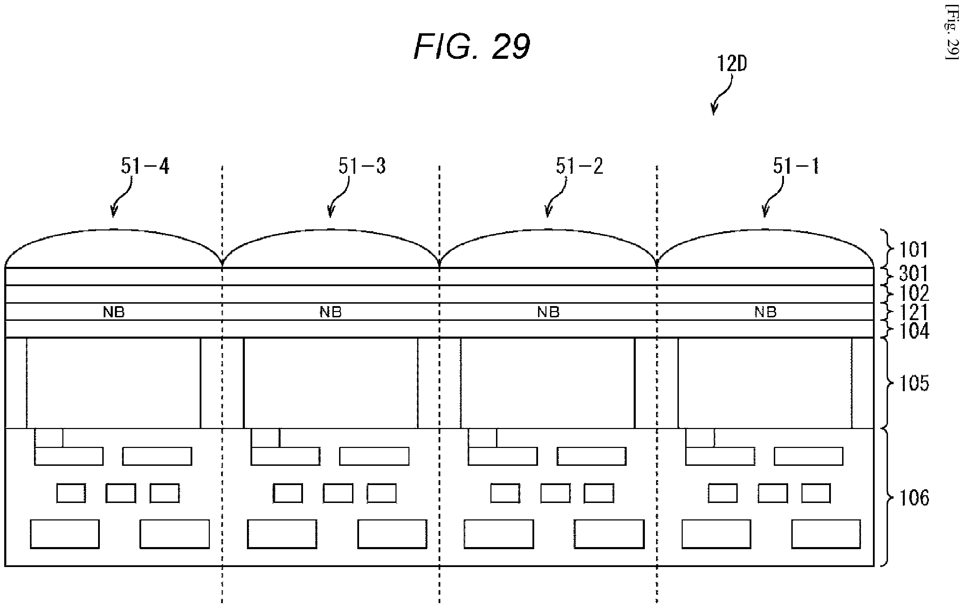

Fig. 29 is a diagram illustrating a configuration of an example of the imaging element 12 (referred to as an imaging element 12D) in a case where, for example, the wire grid type polarizer is laminated, in the polarizer 301 described above.

The wire grid type polarizer 301 is capable of being formed in the imaging element 12D, and thus, as illustrated in Fig. 29, the polarizer 301 can be laminated on an upper layer of the interlayer film 102 laminated on an upper portion of the plasmon filter 121.

The configuration of the imaging element 12D illustrated in Fig. 29 and the configuration of the imaging element 12A illustrated in Fig. 3 are basically similar configurations, but the configuration of the imaging element 12D illustrated in Fig. 29 is different from the configuration of the imaging element 12A illustrated in Fig. 3 in that the polarizer 301 is formed between the on-chip microlens 101 and the interlayer film 102. Furthermore, a layer on which the plasmon filter 121 of the imaging element 12D illustrated in Fig. 29 is laminated corresponds to a layer on which the narrow band filter layer 103 is laminated in the imaging element 12A illustrated in Fig. 3.

In addition, in a case where the polarizer 301 is disposed with respect to the imaging element B in which the color filter layer 107 illustrated in Fig. 16 is disposed, the color filter layer 107 can be disposed on the upper side of the polarizer 301 (the on-chip microlens 101 side) or the lower side of the polarizer 301 (the interlayer film 102 side).

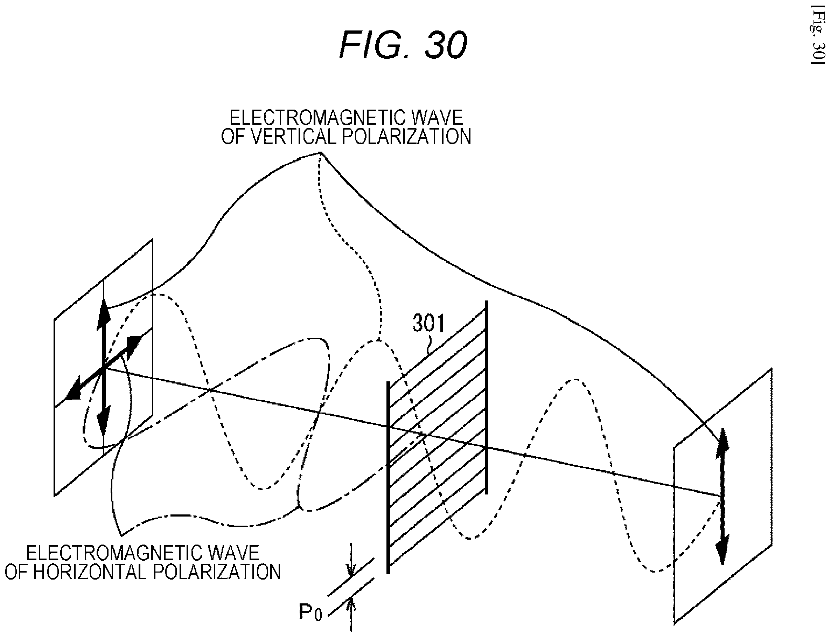

The wire grid type polarizer 301, for example, is the polarizer 301 having a shape as illustrated in Fig. 30. The wire grid type polarizer 301 has a one-dimensional or two-dimensional grid-like structure formed of a conductor material. As illustrated in Fig. 30, in a case where a formation pitch P0 of wire grids is significantly smaller than the wavelength of an incident electromagnetic wave, an electromagnetic wave vibrating in a plain surface parallel to an extension direction of the wire grid is selectively reflected and absorbed on the wire grid.

For this reason, as illustrated in Fig. 30, an electromagnetic wave reaching the wire grid type polarizer includes a vertical polarization component and a horizontal polarization component, but an electromagnetic wave transmitting through the wire grid type polarizer is linearly polarized light in which the vertical polarization component is dominant.

Here, in a case of focusing on a visible light wavelength band, there is a case where the formation pitch P0 of the wire grid is less than or equal to the wavelength of the electromagnetic wave incident on the grid type polarizer, and in this case, the polarization component polarized on a surface parallel to the extension direction of the wire grid is reflected or absorbed on the front surface of the wire grid. On the other hand, in a case where the electromagnetic wave including the polarization component polarized on a surface perpendicular to the extension direction of the wire grid is incident on the wire grid, an electric field propagating the front surface of the wire grid is transmitted from a rear surface of the wire grid at the same wavelength as an incident wavelength and in the same polarization azimuth.

Thus, in a case where the wire grid type polarizer 301 and the plasmon filter 121 are combined, the light transmitted through the polarizer 301 is incident on the plasmon filter 121. The light transmitted through the wire grid type polarizer 301 is the electromagnetic wave including the polarization component polarized on the surface perpendicular to the extension direction of the wire grid. Accordingly, the polarizer 301 and the plasmon filter 121 are combined such that a direction perpendicular to the extension direction of the wire grid and the major axis direction of the elliptical hole of the plasmon filter 121 are the same direction.

For example, in the example illustrated in Fig. 30, the light transmitted through the polarizer 301 is an electromagnetic wave including a polarization component in a vertical direction in the drawing, and thus, the major axis of the ellipse of the plasmon filter 121 is configured in the vertical direction in the drawing.

Thus, in a case where the wire grid type polarizer 301 and the plasmon filter 121 are in a laminated structure, the wire grid type polarizer 301 and the plasmon filter 121 are laminated such that the TE wave from the polarizer 301 and the major axis direction of the ellipse are the same direction.

<Arrangement of Ellipse>

As described above, the shape of the hole of the plasmon filter 121 is set to the elliptical shape, and thus, it is possible to suitably extract the light at the targeted frequency. Even in a case where the shape of the hole of the plasmon filter 121 is set to the elliptical shape, as with a case of the circular shape, the frequency (color) of the light to be extracted is changed according to the distance between the holes (the hole pitch P) or the opening diameter D.

In other words, even in a case where the shape of the hole of the plasmon filter 121 is set to the elliptical shape, as with a case of the circular shape, it is necessary to set the distance between the holes (the hole pitch P) or the opening diameter D to the distance or the size corresponding to the light (the wavelength) to be extracted.

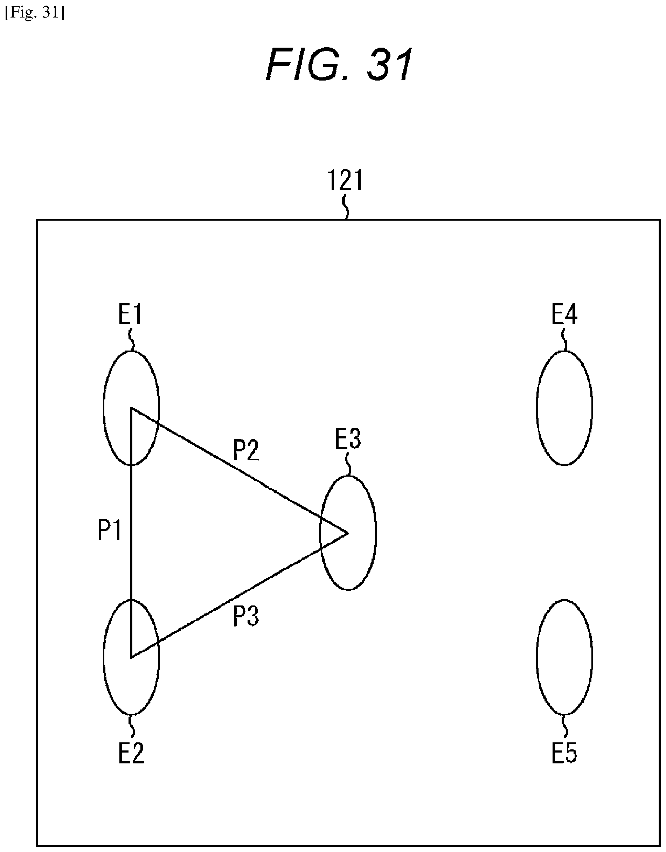

Fig. 31 is a diagram illustrating a part of the plasmon filter 121 when the shape of the hole of the plasmon filter 121 is set to the elliptical shape. In Fig. 31, five ellipses are illustrated as a part of the plasmon filter 121.

A distance between the center of an ellipse E1 and the center of an ellipse E2 is set to P1, a distance between the center of the ellipse E1 and the center of an ellipse E3 is set to P2, and a distance between the center of the ellipse E2 and the center of the ellipse E3 is set to P3. The ellipse E1, the ellipse E2, and the ellipse E3 are arranged such that the distance P1, the distance P2, and the distance P3 are the same length. That is, the respective ellipses are arranged such that a distance between the adjacent ellipses is the same distance.

Thus, even when the shape of the hole of the plasmon filter 121 is set to the elliptical shape, as with a case of the circular shape, the distance between the adjacent holes is formed to be the same, and the distance is a distance suitable for the wavelength to be extracted.

In addition, in a case of the circular shape, the diameter of the circle is set to the opening diameter D, and the opening diameter D is set to a size suitable for the wavelength to be extracted, and in a case of the elliptical shape, a long diameter or a short diameter of the ellipse is set to the opening diameter D.

1.

In an exemplary case where the shape of the hole of the plasmon filter 121 is the circular shape, there is no directional property, but in a case of the elliptical shape, there are the directional properties such as a long diameter direction or a short diameter direction. Therefore, the directions of the holes of all pixels provided in the plasmon filter 121 of the pixel array 31 (Fig. 2) may be the same direction, or may be a direction different for each of the pixels.

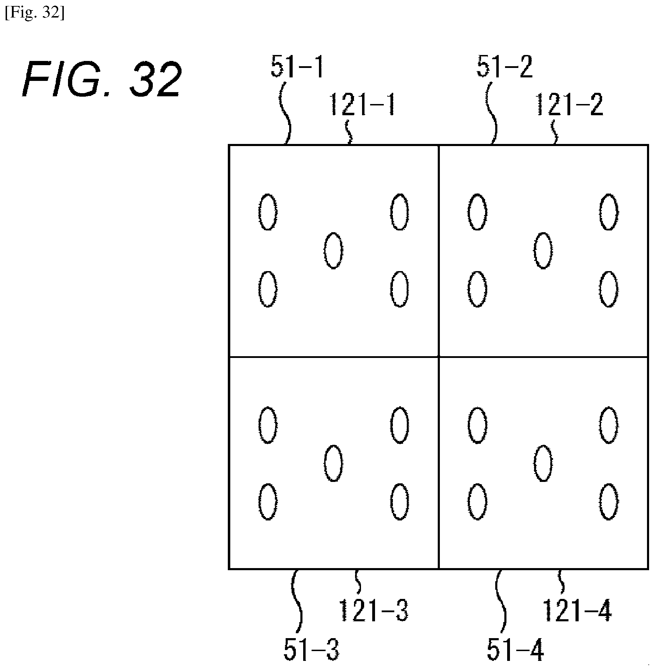

Four pixels of 2*2 will be described as an example. For example, as illustrated in Fig. 32, a pixel 51-1 to pixel 51-4 are arranged, and plasmon filters 121-1 to 121-4 are laminated on each of the pixels 51.

The shapes of the holes of the plasmon filters 121-1 to 121-4 are respectively set to the elliptical shape, and the direction of the long diameter is a vertical direction in the drawing. Thus, the directions of the elliptical holes of the plasmon filter 121 can be the same direction in all of the pixels.

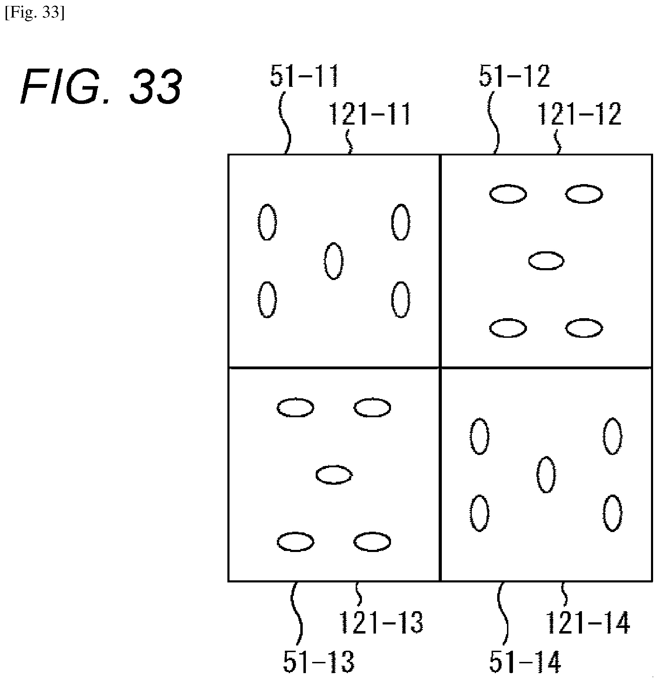

As illustrated in Fig. 33, the direction of the hole may be a direction different for each of the pixels. As with Fig. 32, Fig. 33 illustrates an example where four pixels of 2*2 are arranged. A pixel 51-11 to a pixel 51-14 are arranged, and plasmon filters 121-11 to 121-14 are laminated on each of the pixels 51.

The shapes of the holes of the plasmon filters 121-11 to 121-14 are respectively the elliptical shape. The long diameter direction of the elliptical hole of the plasmon filter 121-11 is set to the vertical direction, the long diameter direction of the elliptical hole of the plasmon filter 121-12 is set to the horizontal direction, the long diameter direction of the elliptical hole of the plasmon filter 121-13 is set to the horizontal direction, and the long diameter direction of the elliptical hole of the plasmon filter 121-14 is set to the vertical direction.

Thus, the direction of the elliptical hole of the plasmon filter 121 can be a direction different for each of the pixels. Thus, the direction of the elliptical hole of the plasmon filter 121 is set to the direction different for each of the pixels, and thus, it is possible to obtain an electromagnetic wave including a polarization component different for each of the pixels.

Furthermore, in Figs. 32 and 33, an example has been described in which the long diameter direction of the ellipse is the vertical direction or the horizontal direction, but may be an oblique direction.

Furthermore, even though it is not illustrated in Fig. 32 or Fig. 33, the polarizer 301 laminated on the plasmon filter 121 is also laminated in a direction which is the direction of the elliptical hole of the plasmon filter 121. For example, in a case of using the wire grid type polarizer 301 described above, the direction of the wire grid is set to a direction different for each of the pixels, and in the direction, the TE wave from the polarizer 301 and the major axis direction of the ellipse are arranged to be in the same direction.

Thus, the shape of the hole of the plasmon filter 121 is set to the elliptical shape, and thus, it is possible to improve the spectral characteristics. In particular, the spectral characteristics on the long wavelength side are improved, compared to the circular shape. In addition, it is possible to obtain excellent spectral characteristics up to near infrared light.

In addition, the shape of the hole of the plasmon filter 121 is set to the elliptical shape, and the polarizer is laminated, and thus, it is possible to further improve the spectral characteristics. A polarization direction in the polarizer and the direction of the ellipse (the long diameter direction) are adjusted, and thus, it is possible to adjust the spectral characteristics. In particular, the polarization direction in the polarizer and the direction of the ellipse (the long diameter direction) are matched to each other, and thus, it is possible to obtain excellent spectral characteristics.

In addition, the shape of the hole of the plasmon filter 121 is set to the elliptical shape, and thus, it is possible to evenly distribute electric field sensitivity. For example, this applicant has confirmed that in a case where the shape of the hole of the plasmon filter 121 is set to a quadrangular shape, the electric field sensitivity is concentrated on a corner portion. On the other hand, in a case of the elliptical shape, this applicant has confirmed that the electric field sensitivity is not concentrated, and is approximately evenly distributed.

In a case where there is a portion collecting the electric field sensitivity, there is a possibility that the characteristics are degraded, but the shape of the hole of the plasmon filter 121 is set to the elliptical shape, and thus, it is possible to evenly distribute the electric field sensitivity, and to prevent the characteristics from being degraded.

Furthermore, a case where the plasmon filter 121 is formed in a hole array has been described as an example, but even in a case of a dot array, the present technology can be applied thereto. In a case where the plasmon filter 121 is formed in the dot array, the shape of the dot is set to the elliptical shape.

In addition, in a case where the plasmon filter 121 is formed in the dot array, and the shape of the dot is set to the elliptical shape, it is possible to obtain a filter absorbing the electromagnetic wave at the targeted frequency with an excellent accuracy.

In addition, the present technology is not limited only to the back-side illumination type CMOS image sensor described above, but can be applied to other imaging elements using the plasmon filter. For example, the present technology can be applied to a surface irradiation type CMOS image sensor, a charge coupled device (CCD) image sensor, an image sensor having a photoconductor structure in which an organic photoelectric conversion film, a quantum dot structure, or the like is embedded, and the like.

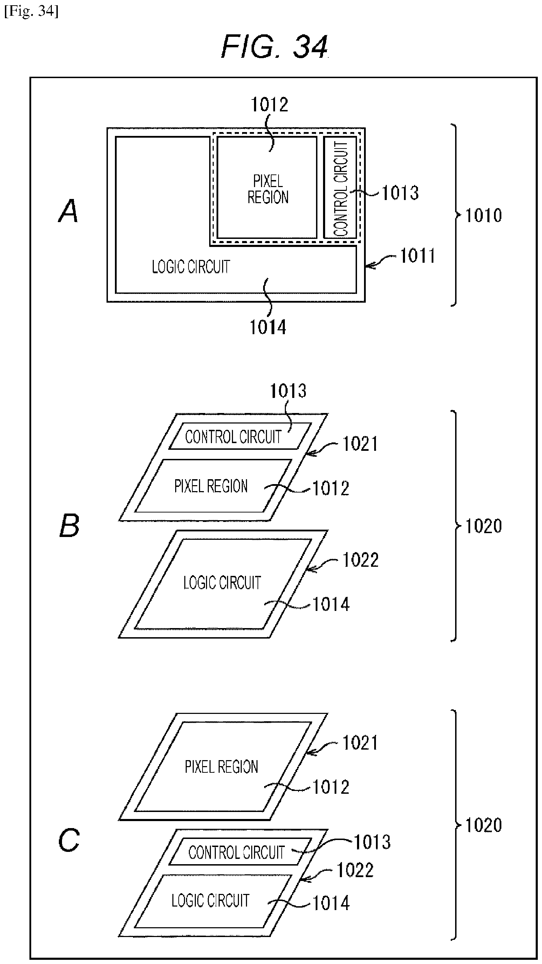

In addition, the present technology, for example, can be applied to a laminated solid imaging device illustrated in Figs. 34A to 34C.

Fig. 34A illustrates a schematic configuration example of a non-laminated solid imaging device. As illustrated in Fig. 34A, a solid imaging device 1010 includes one die (a semiconductor substrate) 1011. A pixel region 1012 in which the pixels are arranged in the shape of an array, a control circuit 1013 performing various controls other than the driving of the pixel, and logic circuit 1014 for signal processing are mounted on the die 1011.

Figs. 34B and 34C illustrate schematic configuration examples of a laminated solid imaging device. As illustrated in Figs. 34B and 34C, two dies of a sensor die 1021 and a logic die 1022 are laminated on a solid imaging device 1020, are electrically connected to each other, and are configured as one semiconductor chip.

In Fig. 34B, the pixel region 1012 and the control circuit 1013 are mounted on the sensor die 1021, and the logic circuit 1014 including a signal processing circuit which performs the signal processing is mounted on the logic die 1022.

In Fig. 34C, the pixel region 1012 is mounted on the sensor die 1021, and the control circuit 1013 and the logic circuit 1014 are mounted on the logic die 1024.

Further, the present technology can be applied to a metal thin film filter using a metal thin film, other than the plasmon filter, and as an application example, a possibility that the present technology is applied to a photonic crystal using a semiconductor material or a Fabry-Perot interference type filter is also considered.

«Application Example»

Next, an application example of the present technology will be described.

<Application Example of Present Technology>

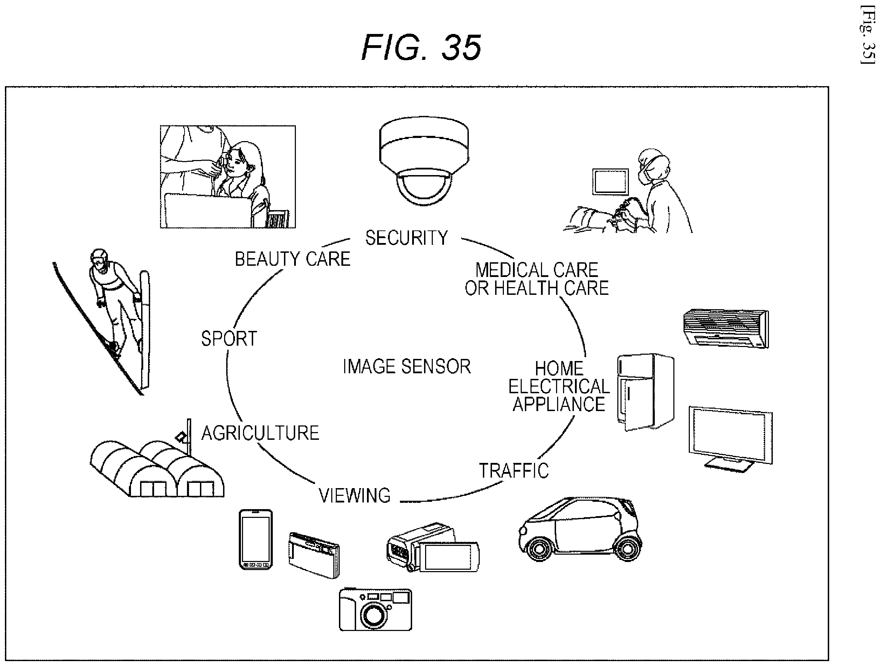

For example, as illustrated in Fig. 35, the present technology can be applied to various cases of sensing light such as visible light, infrared light, ultraviolet light, and an X ray.

- a device shooting an image provided for viewing, such as a digital camera or portable device having a camera function
- a device provided for traffic, such as an in-vehicle sensor shooting the front side, the rear side, the circumference, the inside, or the like of the automobile, a monitoring camera monitoring a running vehicle or a road, and a distance measuring sensor measuring a distance between vehicles or the like, in order for a safety operation such as automatic stop, the recognition of the state of a driver, and the like
- a device provided for a home electrical appliance, such as a TV, a refrigerator, and an air conditioner, in order to shoot the gesture of the user, and to perform a device operation according to the gesture
- a device provided for a medical care or a health care, such as an endoscope or a device performing angiography by receiving infrared light
- a device provided for security, such as a monitoring camera for anti-crime and a camera for personal authentication
- a device provided for a beauty care, such as a skin measuring machine shooting the skin and a microscope shooting the scalp
- a device provided for sport, such as an action camera or a wearable camera for sport
- a device provided for agriculture, such as a camera monitoring the state of the cultivation or the crop

Hereinafter, a more detailed application example will be described.

For example, the transmission band of the narrow band filter NB of each of the pixels 51 of the imaging device 10 of Fig. 1 is adjusted, and thus, a wavelength band of light which is detected by each of the pixels 51 of the imaging device 10 (hereinafter, referred to as a detection band) can be adjusted. Then, the detection band of each of the pixels 51 is suitably set, and thus, the imaging device 10 can be used for various applications.

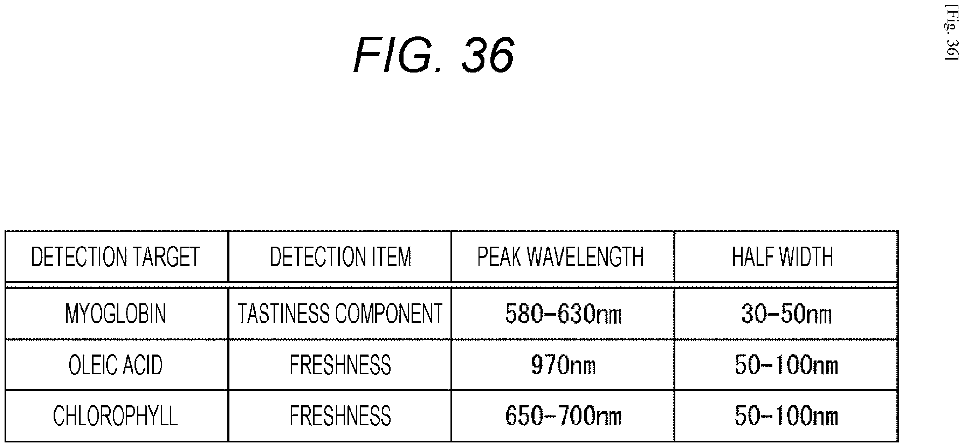

For example, Fig. 36 illustrates an example of a detection band in a case where the tastiness or the freshness of the food is detected.

For example, a peak wavelength of a detection band in the case of detecting myoglobin representing a tastiness component of tuna, beef, or the like is in a range of 580 nm to 630 nm, and a half width is in a range of 30 nm to 50 nm. A peak wavelength of a detection band in the case of detecting an oleic acid representing the freshness of the tuna, the beef, or the like is 980 nm, and a half width is in a range of 50 nm to 100 nm. A peak wavelength of a detection band in the case of detecting chlorophyll representing the freshness of leaf vegetable such as brassica rapa is in a range of 650 nm to 700 nm, and a half width is in a range of 50 nm to 100 nm.

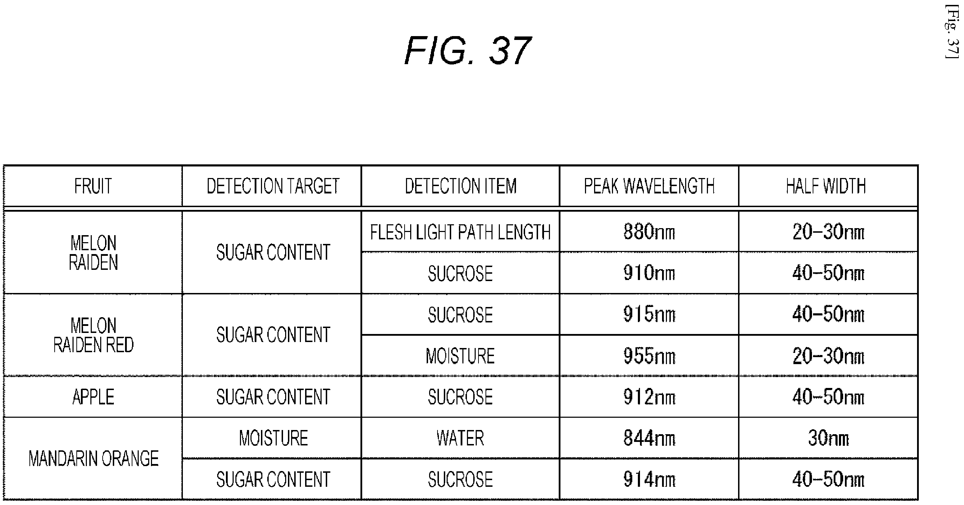

Fig. 37 illustrates an example of a detection band in a case where a sugar content or the moisture of a fruit is detected.

For example, a peak wavelength of a detection band in the case of detecting a flesh light path length representing a sugar content of Raiden, which is one breed of melon, is 880 nm, and a half width is in a range of 20 nm to 30 nm. A peak wavelength of a detection band in the case of detecting sucrose representing the sugar content of Raiden is 910 nm, and a half width is in a range of 40 nm to 50 nm. A peak wavelength of a detection band in the case of detecting sucrose representing a sugar content of Raiden Red, which is another breed of melon, is 915 nm, and a half width is in a range of 40 nm to 50 nm. A peak wavelength of a detection band in the case of detecting moisture representing the sugar content of Raiden Red is 955 nm, and a half width is in a range of 20 nm to 30 nm.

A peak wavelength of a detection band in the case of detecting sucrose representing a sugar content of an apple is 912 nm, and a half width is in a range of 40 nm to 50 nm. A peak wavelength of a detection band in the case of detecting water representing the moisture of a mandarin orange is 844 nm, and a half width is 30 nm. A peak wavelength of a detection band in the case of detecting sucrose representing a sugar content of the mandarin orange is 914 nm, and a half width is in a range of 40 nm to 50 nm.

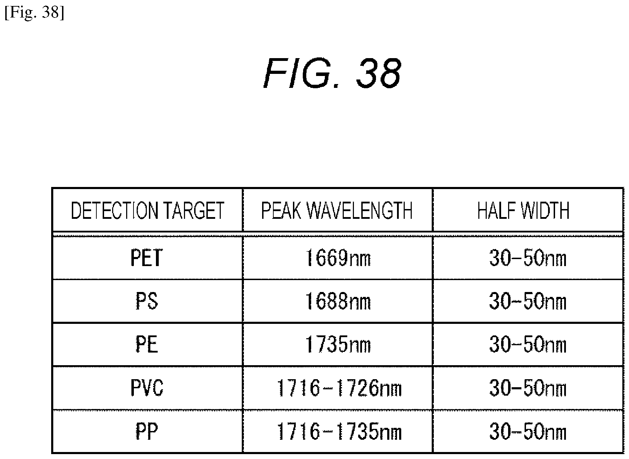

Fig. 38 illustrates an example of a detection band in a case where plastics are sorted.

For example, a peak wavelength of a detection band in the case of detecting poly ethylene terephthalate (PET) is 1669 nm, and a half width is in a range of 30 nm to 50 nm. A peak wavelength of a detection band in the case of detecting poly styrene (PS) is 1688 nm, and a half width is in a range of 30 nm to 50 nm. A peak wavelength of a detection band in the case of detecting poly ethylene (PE) is 1735 nm, and a half width is in a range of 30 nm to 50 nm. A peak wavelength of a detection band in the case of detecting poly vinyl chloride (PVC) is in a range of 1716 nm to 1726 nm, and a half width is in a range of 30 nm to 50 nm. A peak wavelength of a detection band in the case of detecting polypropylene (PP) is in a range of 1716 nm to 1735 nm, and a half width is in a range of 30 nm to 50 nm.

In addition, for example, the present technology can be applied to freshness management of plucked flower.

Further, for example, the present technology can be applied to an inspection of foreign substances which are mixed into the food. For example, the present technology can be applied to the detection of the foreign substances, such as a shell, a hull, a stone, a leaf, a branch, and a wood chip, which are mixed into nuts, such as an almond, a blueberry, and a walnut, or fruits. In addition, for example, the present technology can be applied to the detection of the foreign substances such as plastic pieces mixed into processed food, beverage, or the like.

Further, for example, the present technology can be applied to the detection of a normalized difference vegetation index (NDVI), which is an index of vegetation.

In addition, for example, the present technology can be applied to the detection of a human body on the basis of any one or both of a spectral shape in the vicinity of a wavelength of 580 nm, derived from Hemoglobin of the human skin and a spectral shape in the vicinity of a wavelength of 960 nm, derived from a melanin dye contained in the human skin.

Further, for example, the present technology can be applied to biological detection (biological authentication), fabrication prevention, monitoring, and the like of a user interface and a sign.

<Application Example of Endoscopic Surgery System>

In addition, for example, a technology according to an embodiment of the present disclosure (the present technology) may be applied to an endoscopic surgery system.

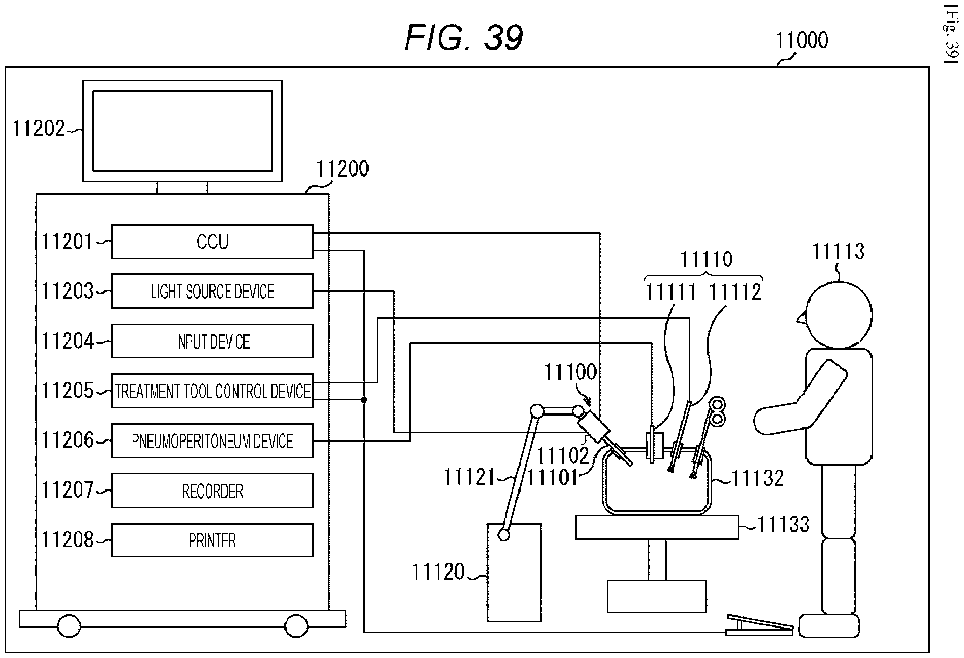

Fig. 39 is a diagram illustrating an example of a schematic configuration of the endoscopic surgery system to which the technology according to an embodiment of the present disclosure (the present technology) is applied.

Fig. 39 illustrates an aspect in which an operator (a medical doctor) 11131 performs a surgery with respect to a patient 11132 on a patient bed 11133 by using an endoscopic surgery system 11000. As illustrated in the drawing, the endoscopic surgery system 11000 is configured of an endoscope 11100, other surgical tools 11110 such as a pneumoperitoneum tube 11111 or an energy treatment tool 11112, a support arm device 11120 supporting the endoscope 11100, and a cart 11200 on which various devices for the surgery under the endoscope are mounted.

The endoscope 11100 is configured of a lens barrel 11101 in which a region having a predetermined length from a tip end is inserted into a body cavity of the patient 11132, and a camera head 11102 connected to a base end of the lens barrel 11101. In the illustrated example, the endoscope 11100 configured as a so-called rigid scope including a rigid lens barrel 11101 is illustrated, and the endoscope 11100 may be configured as a so-called flexible scope including a flexible lens barrel.

An opening portion embedded with an objective lens is disposed on the tip end of the lens barrel 11101. A light source device 11203 is connected to the endoscope 11100, and light generated by the light source device 11203 is guided to the tip end of the lens barrel by a light guide extending in the lens barrel 11101, and is emitted towards an observation target in the body cavity of the patient 11132 through the objective lens. Furthermore, the endoscope 11100 may be a direct view mirror, or may be a perspective view mirror or a side view mirror.

An optical system and an imaging element are disposed on the camera head 11102, and reflection light from the observation target (observation light) is condensed on the imaging element by the optical system. The observation light is subjected to photoelectric conversion by the imaging element, and thus, an electric signal corresponding to the observation light, that is, an image signal corresponding to the observation image is generated. The image signal is transmitted to a camera control unit (CCU) 11201 as RAW data.

The CCU 11201 is configured of a central processing unit (CPU), a graphics processing unit (GPU), or the like, and integrally controls the operations of the endoscope 11100 and a display device 11202. Further, the CCU 11201 receives the image signal from the camera head 11102, and performs various image processings for displaying an image based on the image signal with respect to the image signal, such as developing processing (demosaic processing).

The display device 11202 displays the image based on the image signal, which is subjected to the image processing by the CCU 11201, according to the control from the CCU 11201.

The light source device 11203, for example, is configured of a light source such as a light emitting diode (LED), and supplies irradiation light at the time of shooting a surgical site or the like to the endoscope 11100.

An input device 11204 is an input interface with respect to the endoscopic surgery system 11000. It is possible for the user to perform various information inputs or instruction inputs with respect to the endoscopic surgery system 11000 through the input device 11204. For example, the user inputs an instruction or the like to the effect of changing imaging conditions of the endoscope 11100 (the type of irradiation light, a magnification, a focal point distance, and the like).

A treatment tool control device 11205 controls the drive of the energy treatment tool 11112, such as the cauterization of tissues, and the incision or the sealing of a blood vessel. A pneumoperitoneum device 11206 feeds gas in the body cavity through the pneumoperitoneum tube 11111, in order to inflate the body cavity of the patient 11132 to ensure a visual field of the endoscope 11100 and an operation space of the operator. A recorder 11207 is a device which is capable of recording various information items relevant to the surgery. A printer 11208 is a device which is capable of printing various information items relevant to the surgery in various formats such as a text, an image, or a graph.

Furthermore, the light source device 11203 supplying the irradiation light at the time of shooting the surgical site to the endoscope 11100, for example, can be configured of a white light source which is configured of an LED, a laser light source, or a combination thereof. In a case where the white light source is configured of a combination of RGB laser light sources, an output intensity and an output timing of each color (each wavelength) can be controlled with a high accuracy, and thus, a white balance of the imaged image can be adjusted in the light source device 11203. In addition, in this case, the RGB laser light source irradiates the observation target with each laser light ray in time division, and controls the driving of the imaging element of the camera head 11102 in synchronization with the irradiation timing, and thus, it is also possible to image an image corresponding to each of RGB in time division. According to the method described above, it is possible to obtain a color image even in a case where the color filter is not disposed in the imaging element.

In addition, the light source device 11203 may control the driving such that the light intensity to be output is changed for each predetermined time. The driving of the imaging element of the camera head 11102 is controlled in synchronization with a timing at which the light intensity is changed, an image is acquired in time division, and the image is synthesized, and thus, it is possible to generate an image in a high dynamic range without having so-called black defects and overexposure.

In addition, the light source device 11203 may be configured to be capable of supplying light in a predetermined wavelength band corresponding to special light observation. In the special light observation, for example, light in a narrow band, compared to the irradiation light (that is, white light) at the time of normal observation, is emitted by using wavelength dependency of light absorption in the body tissues, and thus, so-called narrow band light observation (narrow band imaging) shooting a predetermined tissue of the blood vessel or the like on a surface layer of a mucous membrane with a high contrast is performed. Alternatively, in the special light observation, fluorescent light observation may be performed in which an image is obtained by fluorescent light generated by emitting excitation light. In the fluorescent light observation, the body tissues are irradiated with the excitation light, and thus, the fluorescent light from the body tissues can be observed (self-fluorescent light observation), or a reagent such as indocyanine green (ICG) is locally injected into the body tissues, and the body tissues are irradiated with excitation light corresponding to the wavelength of the fluorescent light of the reagent, and thus, a fluorescent image can be obtained. The light source device 11203 can be configured to be capable of supplying the narrow band light and/or the excitation light corresponding to the special light observation.

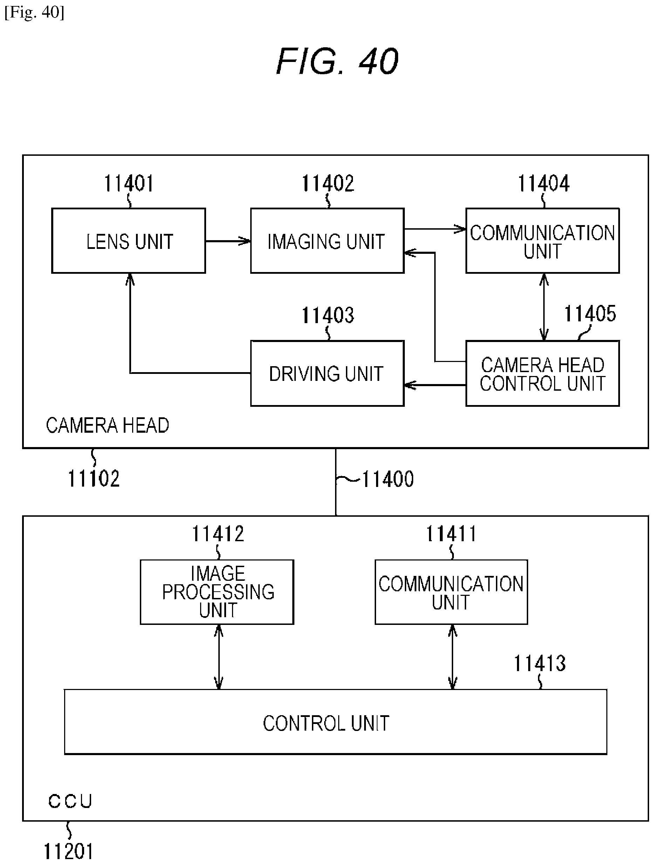

Fig. 40 is a block diagram illustrating an example of functional configurations of the camera head 11102 and the CCU 11201 illustrated in Fig. 39.

The camera head 11102 includes a lens unit 11401, an imaging unit 11402, a driving unit 11403, a communication unit 11404, and a camera head control unit 11405. The CCU 11201 includes a communication unit 11411, an image processing unit 11412, and a control unit 11413. The camera head 11102 and the CCU 11201 are connected to each other to communicate with each other by a transmission cable 11400.

The lens unit 11401 is an optical system which is disposed in a connection portion with respect to the lens barrel 11101. The captured observation light from the tip end of the lens barrel 11101 is guided to the camera head 11102, and is incident on the lens unit 11401. The lens unit 11401 is configured of a combination of a plurality of lenses including a zoom lens and a focus lens.

The imaging element configuring the imaging unit 11402 may be one imaging element (a so-called single-plate type imaging element), or may be a plurality of imaging elements (a so-called multi-plate type imaging element). In a case where the imaging unit 11402 is configured of the multi-plate type imaging element, for example, image signals corresponding to each of RGB are generated by each of the imaging elements, and are synthesized, and thus, a color image may be obtained. Alternatively, the imaging unit 11402 may be configured to include a pair of imaging elements for acquiring image signals for a right eye and a left eye, which correspond to three-dimensional (3D) display. By performing the 3D display, it is possible for the operator 11131 to more accurately grasp the depth of the body tissues in the surgical site. Furthermore, in a case where the imaging unit 11402 is configured of the multi-plate type imaging element, a plurality of lens units 11401 can also be disposed corresponding to each of the imaging elements.

In addition, the imaging unit 11402 may not be necessarily disposed on the camera head 11102. For example, the imaging unit 11402 may disposed in the lens barrel 11101 immediately behind the objective lens.

The driving unit 11403 is configured of an actuator, and moves the zoom lens and the focus lens of the lens unit 11401 along an optical axis by a predetermined distance, according to the control from the camera head control unit 11405. Accordingly, the magnification and the focal point of the imaged image obtained by the imaging unit 11402 can be suitably adjusted.

The communication unit 11404 is configured of a communication device for transmitting and receiving various information items with respect to the CCU 11201. The communication unit 11404 transmits the image signal obtained from the imaging unit 11402 to the CCU 11201 through the transmission cable 11400, as RAW data.

In addition, the communication unit 11404 receives a control signal for controlling the driving the camera head 11102 from the CCU 11201, and supplies the control signal to the camera head control unit 11405. The control signal, for example, includes information relevant to the imaging conditions, such as information to the effect of designating a frame rate of the imaged image, information to the effect of designating an exposure value at the time of imaging, and/or information to the effect of designating the magnification and the focal point of the imaged image.

Furthermore, the imaging conditions such as the frame rate or the exposure value, the magnification, and the focal point, described above, may be suitably designated by the user, or may be automatically set by the control unit 11413 of the CCU 11201 on the basis of the acquired image signal. In the latter case, a so-called auto exposure (AE) function, an auto focus (AF) function, and an auto white balance (AWB) function are mounted on the endoscope 11100.

The camera head control unit 11405 controls the driving of the camera head 11102 on the basis of the control signal from the CCU 11201, which is received through the communication unit 11404.

The communication unit 11411 is configured of a communication device for transmitting and receiving various information items with respect to the camera head 11102. The communication unit 11411 receives the image signal transmitted through the transmission cable 11400 from the camera head 11102.

In addition, the communication unit 11411 transmits the control signal for controlling the driving of the camera head 11102 to the camera head 11102. The image signal or the control signal can be transmitted by telecommunication, light communication, or the like.

The image processing unit 11412 performs various image processings with respect to the image signal, which is the RAW data transmitted from the camera head 11102.

The control unit 11413 performs various controls relevant to the imaging of the surgical site or the like using the endoscope 11100 and the display of the imaged image obtained by imaging the surgical site or the like. For example, the control unit 11413 generates the control signal for controlling the driving of the camera head 11102.

In addition, the control unit 11413 displays the imaged image, on which the surgical site or the like is reflected, on the display device 11202, on the basis of the image signal which is subjected to the image processing by the image processing unit 11412. At this time, the control unit 11413 may recognize various objects in the imaged image by using various image recognition technologies. For example, the control unit 11413 detects the shape, the color, or the like of the edge of the object which is included in the imaged image, and thus, is capable of recognizing a surgical tool such as forceps, a specific organic site, bleed, mist at the time of using the energy treatment tool 11112, or the like. The control unit 11413 may display various surgery assistance information items by superimpose the information on the image of the surgical site, by using the recognition result, at the time of displaying the imaged image on the display device 11202. The surgery assistance information is displayed by being superimposed, and is presented to the operator 11131, and thus, it is possible to reduce a load on the operator 11131, and it is possible for the operator 11131 to reliably perform the surgery.

The transmission cable 11400 connecting the camera head 11102 and the CCU 11201 to each other is an electric signal cable corresponding to the communication of the electric signal, an optical fiber corresponding to the light communication, or a composite cable thereof.

Here, in the illustrated example, the communication is performed in a wired manner by using the transmission cable 11400, and the communication between the camera head 11102 and the CCU 11201 may be performed in a wireless manner.

As described above, an example of the endoscopic surgery system which can be obtained by applying the technology according to an embodiment of the present disclosure thereto has been described. In the configurations described above, the technology according to an embodiment of the present disclosure, for example, can be obtained by being applied to the camera head 11102 or the imaging unit 11402 of the camera head 11102. Specifically, for example, the imaging element 12 of Fig. 1 can be applied to the imaging unit 11402. It is possible to obtain a more specific and high accurate surgical site image by applying the technology according to an embodiment of the present disclosure to the imaging unit 11402, and thus, it is possible for the operator to reliably confirm the surgical site.

Furthermore, here, the endoscopic surgery system has been described as an example, but the technology according to an embodiment of the present disclosure, for example, may be applied to a microscope surgery system or the like in addition to the endoscopic surgery system.

<Application Example to Movable Body>

In addition, for example, the technology according to an embodiment of the present disclosure may be realized as a device mounted on any type of movable body such as an automobile, an electric automobile, a hybrid electric automobile, a motorcycle, a bicycle, a personal mobility, an airplane, a drone, a ship, and a robot.

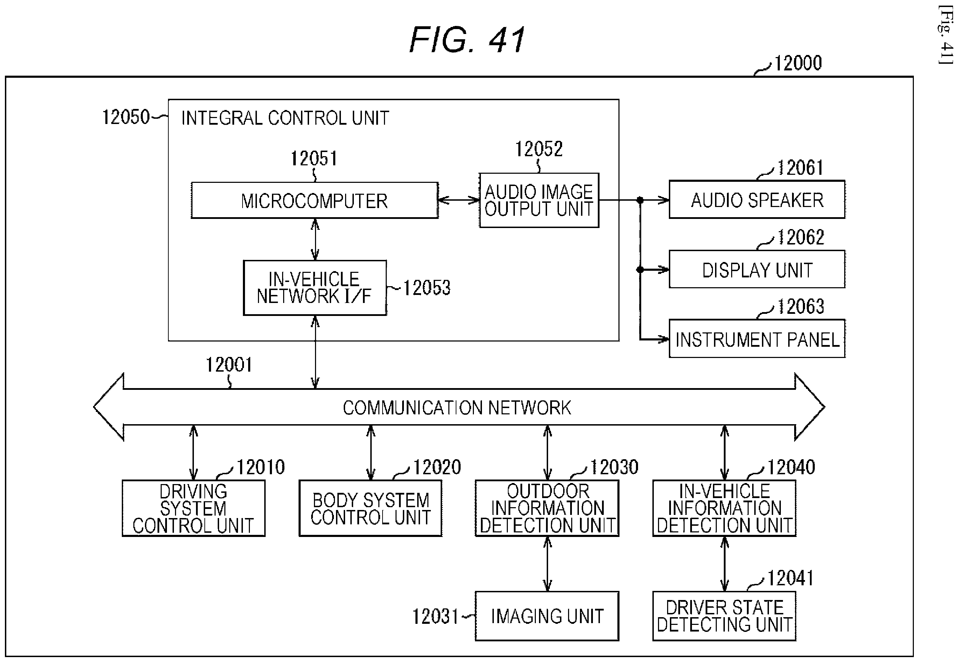

Fig. 41 is a block diagram illustrating a schematic configuration example of a vehicle control system, which is an example of a movable body control system obtained by applying the technology according to an embodiment of the present disclosure thereto.

A vehicle control system 12000 includes a plurality of electronic control units connected to each other through a communication network 12001. In the example illustrated in Fig. 41, the vehicle control system 12000 includes a driving system control unit 12010, a body system control unit 12020, an outdoor information detection unit 12030, an in-vehicle information detection unit 12040, and an integral control unit 12050. In addition, a microcomputer 12051, an audio image output unit 12052, and an in-vehicle network interface (I/F) 12053 are illustrated as a functional configuration of the integral control unit 12050.

The driving system control unit 12010 controls an operation of a device relevant to a driving system of the vehicle according to various programs. For example, the driving system control unit 12010 functions as a control device of a driving force generating device for generating a driving force of a vehicle, such as an internal-combustion engine or a driving motor, a driving force transfer mechanism for transferring the driving force to a wheel, a steering mechanism adjusting a rudder angle of the vehicle, a braking device generating a braking force of the vehicle, and the like.

The body system control unit 12020 controls the operations of various devices mounted on a vehicle body according to various programs. For example, the body system control unit 12020 functions as a control device of a keyless entry system, a smart key system, an electric window device, and various lamps such as a head lamp, a back lamp, a brake lamp, a winker lamp, or a fog lamp. In this case, an electric wave transmitted from a portable machine instead of a key or signals of various switches can be input into the body system control unit 12020. The body system control unit 12020 receives the input of the electric wave or the signal, and controls the door lock device, the electric window device, the lamp, and the like of the vehicle.

The outdoor information detection unit 12030 detects the outside information of the vehicle on which the vehicle control system 12000 is mounted. For example, an imaging unit 12031 is connected to the outdoor information detection unit 12030. The outdoor information detection unit 12030 images the outdoor image by the imaging unit 12031, and receives the imaged image. The outdoor information detection unit 12030 may perform object detection processing or distance detection processing of a person, a car, an obstacle, a sign, characters on a road surface, or the like, on the basis of the received image.

The imaging unit 12031 is an optical sensor which receives light and outputs an electric signal according to the amount of the received light. The imaging unit 12031 is capable of outputting the electric signal as an image, and is capable of outputting the electric signal as distance measuring information. In addition, the light received by the imaging unit 12031 may be visible light, or may be non-visible light such as an infrared ray.

The in-vehicle information detection unit 12040 detects in-vehicle information. For example, a driver state detecting unit 12041 detecting the state of the driver is connected to the in-vehicle information detection unit 12040. The driver state detecting unit 12041, for example, includes a camera imaging the driver, and the in-vehicle information detection unit 12040 may calculate a fatigue degree or a concentration degree of the driver, or may determine whether or not the driver dozes off, on the basis of detection information input from the driver state detecting unit 12041.

The microcomputer 12051 calculates a control target value of the driving force generating device, the steering mechanism, or the braking device on the basis of the in-vehicle information and the outdoor information, which are acquired in the outdoor information detection unit 12030 or the in-vehicle information detection unit 12040, and is capable of outputting a control command to the driving system control unit 12010. For example, the microcomputer 12051 is capable of performing cooperative control for realizing the function of an advanced driver assistance system (ADAS) including collision avoidance or impact relaxation of the vehicle, following running based on an inter-vehicle distance, vehicle speed maintaining running, collision warning of the vehicle, lane departure warning of the vehicle, and the like.

In addition, the microcomputer 12051 controls driving force generating device, the steering mechanism, the braking device, or the like, on the basis of the information around the vehicle, which is acquired in the outdoor information detection unit 12030 or the in-vehicle information detection unit 12040, and is capable of performing cooperative control for automated driving in which the vehicle autonomously runs without depending on the operation of the driver.

In addition, the microcomputer 12051 is capable of outputting the control command to the body system control unit 12020, on the basis of the outdoor information, which is acquired in the outdoor information detection unit 12030. For example, the microcomputer 12051 controls the head lamp according to the position of a leading vehicle or an oncoming vehicle, which is detected by the outdoor information detection unit 12030, and thus, is capable of performing cooperative control for glare-proof such as switching the high beam with a low beam.

The audio image output unit 12052 transmits at least one output signal of an audio and an image to an output device which is capable of visually or auditorily notifying a person on board or the outdoor of the vehicle of the information. In the example of Fig. 41, an audio speaker 12061, a display unit 12062, and an instrument panel 12063 are exemplified as the output device. The display unit 12062, for example, may include at least one of an on-board display and a head-up display.

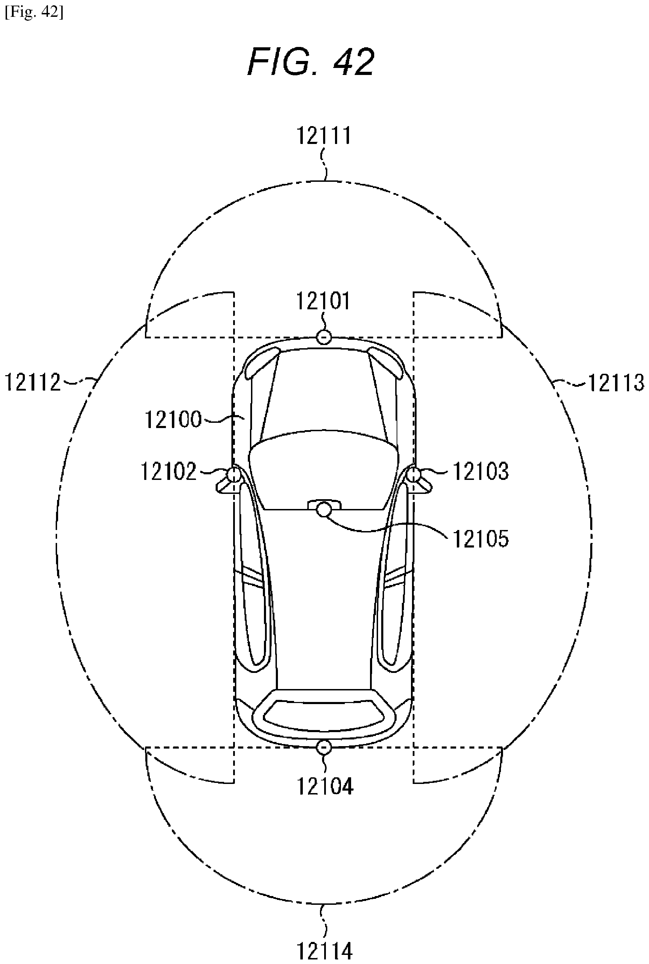

Fig. 42 is a diagram illustrating an example of a disposition position of the imaging unit 12031.

In Fig. 42, the imaging unit 12031 includes imaging units 12101, 12102, 12103, 12104, and 12105.

The imaging units 12101, 12102, 12103, 12104, and 12105, for example, are disposed in positions such as a front nose, a side mirror, a rear bumper, a back door of a vehicle 12100, and an upper portion of a front glass of a vehicle interior. The imaging unit 12101 provided in the front nose and the imaging unit 12105 provided in the upper portion of the front glass of the vehicle interior mainly acquire a front image of the vehicle 12100. The imaging units 12102 and 12103 provided in the side mirror mainly acquire a side image of the vehicle 12100. The imaging unit 12104 provided in the rear bumper or the back door mainly acquires a rear image of the vehicle 12100. The imaging unit 12105 provided in the upper portion of the front glass of the vehicle interior is mainly used for detecting a leading vehicle, a pedestrian, an obstacle, a traffic light, a traffic sign, a traffic lane, or the like.

Furthermore, Fig. 42 illustrates an example of shooting ranges of the imaging units 12101 to 12104. The imaging range 12111 illustrates an imaging range of the imaging unit 12101 provided in the front nose, imaging ranges 12112 and 12113 illustrate imaging ranges of the imaging units 12102 and 12103 respectively provided in the side mirror, and the imaging range 12114 illustrates an imaging range of the imaging unit 12104 provided in the rear bumper or the back door. For example, image data items imaged in the imaging units 12101 to 12104 are superimposed on each other, and thus, an overhead image is obtained in which the vehicle 12100 is viewed from the upper side.

At least one of the imaging units 12101 to 12104 may have a function of acquiring the distance information. For example, at least one of the imaging units 12101 to 12104 may be a stereo camera formed of a plurality of imaging elements, or may be an imaging element including a pixel for detecting a phase difference.

For example, the microcomputer 12051 obtains a distance to each solid object in the imaging ranges 12111 to 12114, and a temporal change of the distance (a relative speed with respect to the vehicle 12100), on the basis of the distance information obtained from the imaging units 12101 to 12104, and thus, in particular, it is possible to extract the solid object running at a predetermined speed (for example, greater than or equal to 0 km/h) in approximately the same direction as that of the vehicle 12100 as the leading vehicle, in the closest solid object on a traveling path of the vehicle 12100. Further, the microcomputer 12051 sets the inter-vehicle distance to be ensured in advance immediately before the leading vehicle, and thus, is capable of performing automatic brake control (also including following stop control), automatic acceleration control (also including following start control), or the like. Thus, it is possible to perform the cooperative control for the automated driving in which the vehicle autonomously runs without depending on the operation of the driver.

For example, it is possible for the microcomputer 12051 to extract solid object data relevant to the solid object by sorting the data into other solid objects such as a two-wheeled vehicle, an ordinary vehicle, a large vehicle, a pedestrian, and a telegraph pole, on the basis of the distance information obtained from the imaging units 12101 to 12104, and to use the data for automatically avoiding the obstacle. For example, the microcomputer 12051 distinguishes the obstacle around the vehicle 12100 between an obstacle which is visible to the driver of the vehicle 12100 and an obstacle which is not visible. Then, the microcomputer 12051 determines collision risk representing a dangerous extent of the collision with respect to each of the obstacles, and in the case of a situation in which the collision risk is greater than or equal to a set value, that is, there is a possibility of the collision, an alarm is output to the driver through the audio speaker 12061 or the display unit 12062, or forced deceleration and avoidance steering is performed through the driving system control unit 12010, and thus, it is possible to perform driving assistance for avoiding the collision.

At least one of the imaging units 12101 to 12104 may be an infrared ray camera detecting an infrared ray. For example, the microcomputer 12051 determines whether or not the pedestrian exists in the imaged images of the imaging units 12101 to 12104, and thus, it is possible to recognize the pedestrian. Such recognition of the pedestrian, for example, is performed in the order of extracting a characteristic point in the imaged images of the imaging units 12101 to 12104 as the infrared ray camera and the order of determining whether or not there is the pedestrian by performing pattern matching processing with respect to a set of characteristic points representing the outline of the object. The microcomputer 12051 determines that the pedestrian exists in the imaged images of the imaging units 12101 to 12104, and in a case where the pedestrian is recognized, the audio image output unit 12052 controls the display unit 12062 such that a rectangular outline for emphasis is displayed by being superimposed on the recognized pedestrian. In addition, the audio image output unit 12052 may control the display unit 12062 such that an icon or the like representing the pedestrian is displayed in a desired position.

As described above, an example of the vehicle control system, which can be obtained by applying the technology according to an embodiment of the present disclosure thereto, has been described. In the configurations described above, the technology according to an embodiment of the present disclosure, for example, can be applied to the imaging unit 12031. Specifically, for example, the imaging device 10 of Fig. 1 can be applied to the imaging unit 12031. By applying the technology according to an embodiment of the present disclosure to the imaging unit 12031, for example, it is possible to more specifically acquire the outdoor information with a higher accuracy, and to realize improvement or the like or the safety of the automated driving.

**Reference Signs List**

10 Imaging device
11 Optical system
12, 12A to 12G Imaging element
14 Signal processing unit
31 Pixel array
51 Pixel
61 Photodiode
101 On-chip microlens
102 Interlayer film
103 Narrow band filter layer
104 Interlayer film
105 Photoelectric conversion element layer
106 Signal wiring layer
107 Color filter layer
108 Filter layer
121 A to 121D Plasmon filter
131A to 131C Conductor thin film
132A to 132C' Hole
133A, 133B Dot
134A, 134B Dielectric layer
151 Plasmon filter
161A Movable thin film
162 SiO2 film
163 SiN film
164 SiO2 substrate
203, 221 Semiconductor chip
301 Polarizer

**Claims**

1. An imaging device, comprising:

a polarizer (301) configured to linearly polarize light along a polarization direction;
a plasmon metal thin film filter layer (121) configured to receive polarized light from the polarizer (301) and selectively filter light according to wavelengths of the polarized light; and
a photoelectric conversion layer configured to receive light filtered by the filter layer (121) and to produce an electric charge in response to the received light,
wherein the plasmon metal thin film filter layer (121) comprises a plurality of through holes and a plurality of non-through holes formed therein and periodically arranged, wherein the through holes and the non-through holes have an elliptical cross-sectional shape when viewed a planar view, and the proportion of the short axis : major axis of the elliptical shape is 66.67% (= 1 :1.5),
wherein a major axis of the ellipse is aligned in the polarization direction.

2. The imaging device of claim 1, wherein the plurality of through holes are arranged in a first array and wherein the plurality of non-through holes are arranged in a second array overlapping the first array, and wherein the second array is a hexagonal array.

3. The imaging device of claim 1, wherein the filter layer (121) comprises a first sublayer having a plurality of through holes formed therein and a second sublayer adjacent to the first sublayer having a plurality of through holes formed therein, wherein at least some of the through holes of the first sublayer are not aligned with a through hole of the second sublayer, thereby forming one or more non-through holes.

4. The imaging device of claim 1, further comprising a first dielectric film (134) disposed on a first side of the filter layer (121) between the filter layer (121) and the photoelectric conversion layer and a second dielectric film (134) disposed on a second side of the filter layer opposing the first side.

5. The imaging device of claim 1, wherein the filter layer (121) comprises aluminum, silver and/or gold, or wherein the polarizer (301) comprises a crystalline material.

6. An imaging device, comprising:

a polarizer (301) configured to linearly polarize light along a polarization direction; a plasmon thin film filter (121) configured to receive polarized light from the polarizer (301) and selectively filter light according to wavelengths of the polarized light; and
a photoelectric conversion layer configured to receive light filtered by the filter layer (121) and to produce an electric charge in response to the received light,
wherein the plasmon thin film filter (121) comprises a dot array arranged in a dielectric layer (134), wherein the dots of the dot array have an elliptical cross-sectional shape, when viewed a planar view, and the proportion of the short axis : major axis of the elliptical shape is 66.67% (1 : 1.5) wherein a major axis of the ellipse is aligned in the polarization direction.

7. The imaging device of claim 6, wherein the dots of the dot array are arranged in a hexagonal array or a square array.

8. An imaging method using the imaging device according to claim 1 or claim 6, the imaging method comprising:

receiving light polarized along a polarization direction;
selectively filtering the received light by the plasmon metal thin filter layer according to wavelengths of the polarized light, , receiving light filtered by the filter layer in a photoelectric conversion layer and producing an electric charge in response to the received filtered light.


**Patentansprüche**

1. Bildgebungsvorrichtung, umfassend:

einen Polarisator (301), ausgelegt zum Linearpolarisieren von Licht entlang einer Polarisationsrichtung;
eine Plasmonen-Metalldünnschicht-Filterschicht (121), ausgelegt zum Empfangen von polarisiertem Licht von dem Polarisator (301) und zum selektiven Filtern von Licht nach den Wellenlängen des polarisierten Lichts; und
eine photoelektrische Umwandlungsschicht, ausgelegt zum Empfangen von durch die Filterschicht (121) gefiltertem Licht und zum Produzieren einer elektrischen Ladung als Reaktion auf das empfangene Licht,

wobei die Plasmonen-Metalldünnschicht-Filterschicht (121) eine Vielzahl von Durchgangslöchern und eine Vielzahl von Sacklöchern umfasst, die darin ausgebildet und periodisch angeordnet sind, wobei die Durchgangslöcher und die Sacklöcher bei Draufsicht eine elliptische Querschnittsform aufweisen, und das Verhältnis der kurzen Achse / Hauptachse der elliptischen Form 66,67 % (1 : 1,5) beträgt,
wobei die Hauptachse der Ellipse in der Polarisationsrichtung ausgerichtet ist.

2. Bildgebungsvorrichtung nach Anspruch 1, wobei die Vielzahl von Durchgangslöchern in einem ersten Array angeordnet ist und wobei die Vielzahl von Sacklöchern in einem zweiten Array angeordnet ist, das das erste Array überlappt, und wobei das zweite Array ein hexagonales Array ist.

3. Bildgebungsvorrichtung nach Anspruch 1, wobei die Filterschicht (121) eine erste Subschicht, die eine Vielzahl von darin ausgebildeten Durchgangslöchern aufweist, und eine zweite Subschicht, an die erste Subschicht angrenzend, die eine Vielzahl von darin ausgebildeten Durchgangslöchern aufweist, umfasst, wobei zumindest einige der Durchgangslöcher der ersten Subschicht nicht mit einem Durchgangsloch der zweiten Subschicht ausgerichtet sind, wodurch ein oder mehrere Sacklöcher ausgebildet werden.

4. Bildgebungsvorrichtung nach Anspruch 1, ferner umfassend eine erste dielektrische Dünnschicht (134), eingerichtet auf einer ersten Seite der Filterschicht (121) zwischen der Filterschicht (121) und der photoelektrischen Umwandlungsschicht, und eine zweite dielektrische Dünnschicht (134), eingerichtet auf einer zweiten Seite der Filterschicht, der ersten Seite entgegengesetzt.

5. Bildgebungsvorrichtung nach Anspruch 1, wobei die Filterschicht (121) Aluminium, Silber und/oder Gold umfasst, oder wobei der Polarisator (301) ein kristallines Material umfasst.

6. Bildgebungsvorrichtung, umfassend:

einen Polarisator (301), ausgelegt zum Linearpolarisieren von Licht entlang einer Polarisationsrichtung;
ein Plasmonen-Dünnschicht-Filter (121), ausgelegt zum Empfangen von polarisiertem Licht von dem Polarisator (301) und zum selektiven Filtern von Licht nach den Wellenlängen des polarisierten Lichts; und
eine photoelektrische Umwandlungsschicht, ausgelegt zum Empfangen von durch die Filterschicht (121) gefiltertem Licht und zum Produzieren einer elektrischen Ladung als Reaktion auf das empfangene Licht,
wobei das Plasmonen-Dünnschicht-Filter (121) ein in einer dielektrischen Schicht (134) angeordnetes Punktarray aufweist, wobei die Punkte des Punktarrays bei Draufsicht eine elliptische Querschnittsform aufweisen, und das Verhältnis der kurzen Achse / Hauptachse der elliptischen Form 66,67 % (1 : 1,5) beträgt,
wobei die Hauptachse der Ellipse in der Polarisationsrichtung ausgerichtet ist.

7. Bildgebungsvorrichtung nach Anspruch 6, wobei die Punkte des Punktarrays in einem hexagonalen Array oder einem quadratischen Array angeordnet sind.

8. Bildgebungsverfahren mit Verwendung der Bildgebungsvorrichtung nach Anspruch 1 oder Anspruch 6, wobei das Bildgebungsverfahren Folgendes umfasst:

Empfangen von entlang einer Polarisationsrichtung polarisiertem Licht;
selektives Filtern des empfangenen Lichts durch eine Plasmonen-Metalldünnschicht-Filterschicht nach Wellenlängen des polarisierten Lichts,
Empfangen von durch die Filterschicht gefiltertem Licht in einer photoelektrischen Umwandlungsschicht und Produzieren einer elektrischen Ladung als Reaktion auf das empfangene gefilterte Licht.

## Revendications

1. Dispositif d'imagerie, comprenant :

un polariseur (301) configuré pour polariser linéairement la lumière le long d'une direction de polarisation ;
une couche de filtre plasmonique à film mince métallique (121) configurée pour recevoir la lumière polarisée provenant du polariseur (301) et filtrer sélectivement la lumière en fonction de longueurs d'onde de la lumière polarisée ; et
une couche de conversion photoélectrique configurée pour recevoir la lumière filtrée par la couche de filtre (121) et pour produire une charge électrique en réponse à la lumière reçue,

dans lequel la couche de filtre plasmonique à film mince métallique (121) comprend une pluralité de trous débouchants et une pluralité de trous non débouchants formés à l'intérieur et disposés périodiquement, dans lequel les trous débouchants et les trous non débouchants ont une forme de section transversale elliptique lorsqu'on les regarde dans une vue en plan, et la proportion du petit axe par rapport au grand axe de la forme elliptique est de 66,67 % (= 1:1,5), dans lequel un grand axe de l'ellipse est aligné dans la direction de polarisation.

2. Dispositif d'imagerie de la revendication 1, dans lequel la pluralité de trous débouchants sont disposés dans un premier réseau et dans lequel la pluralité de trous non débouchants sont disposés dans un deuxième réseau chevauchant le premier réseau, et dans lequel le deuxième réseau est un réseau hexagonal.

3. Dispositif d'imagerie de la revendication 1, dans lequel la couche de filtre (121) comprend une première sous-couche ayant une pluralité de trous débouchants formés à l'intérieur et une deuxième sous-couche adjacente à la première sous-couche ayant une pluralité de trous débouchants formés à l'intérieur, dans lequel au moins certains des trous débouchants de la première sous-couche ne sont pas alignés avec un trou débouchant de la deuxième sous-couche, formant ainsi un ou plusieurs trous non débouchants.

4. Dispositif d'imagerie de la revendication 1, comprenant en outre un premier film diélectrique (134) disposé sur un premier côté de la couche de filtre (121) entre la couche de filtre (121) et la couche de conversion photoélectrique, et un deuxième film diélectrique (134) disposé sur un deuxième côté de la couche de filtre à l'opposé du premier côté.

5. Dispositif d'imagerie de la revendication 1, dans lequel la couche de filtre (121) comprend de l'aluminium, de l'argent et/ou de l'or, ou dans lequel le polariseur (301) comprend un matériau cristallin.

6. Dispositif d'imagerie, comprenant :

un polariseur (301) configuré pour polariser linéairement la lumière le long d'une direction de polarisation ;
un filtre plasmonique à film mince (121) configuré pour recevoir la lumière polarisée provenant du polariseur (301) et filtrer sélectivement la lumière en fonction de longueurs d'onde de la lumière polarisée ; et
une couche de conversion photoélectrique configurée pour recevoir la lumière filtrée par la couche de filtre (121) et pour produire une charge électrique en réponse à la lumière reçue,
dans lequel le filtre plasmonique à film mince (121) comprend un réseau de points disposé dans une couche diélectrique (104), dans lequel les points du réseau de points ont une forme de section transversale elliptique lorsqu'on les regarde dans une vue en plan, et la proportion du petit axe par rapport au grand axe de la forme elliptique est de 66,67 % (= 1:1,5), dans lequel un grand axe de l'ellipse est aligné dans la direction de polarisation.

7. Dispositif d'imagerie de la revendication 6, dans lequel les points du réseau de points sont disposés dans un réseau hexagonal ou un réseau carré.

8. Procédé d'imagerie utilisant le dispositif d'imagerie selon la revendication 1 ou la revendication 6, le procédé d'imagerie comprenant :

la réception de lumière polarisée le long d'une direction de polarisation ;
le filtrage sélectif de la lumière reçue par la couche de filtre plasmonique à film mince en fonction de longueurs d'onde de la lumière polarisée, la réception de la lumière filtrée par la couche de filtre dans une couche de conversion photoélectrique et la production d'une charge électrique en réponse à la lumière filtrée reçue.

[Fig. 1]

EP 3 555 917 B1

## FIG. 1

[Fig. 2]

*FIG. 2*

[Fig. 3]

*FIG. 3*

[Fig. 4]

# FIG. 4

[Fig. 5]

# FIG. 5

[Fig. 6]

FIG. 6

[Fig. 7]

## FIG. 7

EP 3 555 917 B1

[Fig. 8]

FIG. 8

## FIG. 9

[Fig. 9]

EP 3 555 917 B1

[Fig. 10]

# FIG. 10

[Fig. 11]

# FIG. 11

[Fig. 12]

# FIG. 12

[Fig. 13]

## FIG. 13

EP 3 555 917 B1

[Fig. 14]

# FIG. 14

[Fig. 15]

FIG. 15

[Fig. 16]

## FIG. 16

EP 3 555 917 B1

[Fig. 17]

# FIG. 17

EP 3 555 917 B1

[Fig. 18]

*FIG. 18*

EP 3 555 917 B1

[Fig. 19]

FIG. 19

[Fig. 20]

*FIG. 20*

[Fig. 21]

*FIG. 21*

[Fig. 22]

*FIG. 22*

[Fig. 23]

*FIG. 23*

[Fig. 24]

FIG. 24

[Fig. 25]

FIG. 25

[Fig. 26]

FIG. 26

[Fig. 27]

*FIG. 27*

[Fig. 28]

FIG. 28

[Fig. 29]

*FIG. 29*

[Fig. 30]

## FIG. 30

EP 3 555 917 B1

ELECTROMAGNETIC WAVE
OF VERTICAL POLARIZATION

301

ELECTROMAGNETIC WAVE
OF HORIZONTAL POLARIZATION

P0

[Fig. 31]

# FIG. 31

[Fig. 32]

FIG. 32

[Fig. 33]

FIG. 33

[Fig. 34]

# FIG. 34

[Fig. 35]

FIG. 35

[Fig. 36]

EP 3 555 917 B1

# FIG. 36

| DETECTION TARGET | DETECTION ITEM | PEAK WAVELENGTH | HALF WIDTH |
|---|---|---|---|
| MYOGLOBIN | TASTINESS COMPONENT | 580–630nm | 30–50nm |
| OLEIC ACID | FRESHNESS | 970nm | 50–100nm |
| CHLOROPHYLL | FRESHNESS | 650–700nm | 50–100nm |

# FIG. 37

| FRUIT | DETECTION TARGET | DETECTION ITEM | PEAK WAVELENGTH | HALF WIDTH |
|---|---|---|---|---|
| MELON RAIDEN | SUGAR CONTENT | FLESH LIGHT PATH LENGTH | 880nm | 20-30nm |
| | | SUCROSE | 910nm | 40-50nm |
| MELON RAIDEN RED | SUGAR CONTENT | SUCROSE | 915nm | 40-50nm |
| | | MOISTURE | 955nm | 20-30nm |
| APPLE | SUGAR CONTENT | SUCROSE | 912nm | 40-50nm |
| MANDARIN ORANGE | MOISTURE | WATER | 844nm | 30nm |
| | SUGAR CONTENT | SUCROSE | 914nm | 40-50nm |

[Fig. 37]

EP 3 555 917 B1

[Fig. 38]

# FIG. 38

| DETECTION TARGET | PEAK WAVELENGTH | HALF WIDTH |
|:---:|:---:|:---:|
| PET | 1669nm | 30-50nm |
| PS | 1688nm | 30-50nm |
| PE | 1735nm | 30-50nm |
| PVC | 1716-1726nm | 30-50nm |
| PP | 1716-1735nm | 30-50nm |

FIG. 39

[Fig. 40]

# FIG. 40

[Fig. 41]

# FIG. 41

EP 3 555 917 B1

[Fig. 42]

# FIG. 42

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2008170143 A1
- EP 2432019 A1
- WO 2006028128 A
- WO 2005013369 A

**Non-patent literature cited in the description**

- **PAUL F. GOLDSMITH.** Quasioptical Systems. IEEE Press
- **P.B.CATRYSSE ; B.A.WANDELL.** *J. Opt. Soc. Am. A,* December 2003, vol. 20 (12), 2293-2306
- **SEH-WON AHN et al.** *Nanotechnology,* 2005, vol. 16, 1874-1877